(19) **Europäisches Patentamt European Patent Office Office européen des brevets**

(11) **EP 4 449 567 B1**

(12) **EUROPÄISCHE PATENTSCHRIFT**

(45) Veröffentlichungstag und Bekanntmachung des Hinweises auf die Patenterteilung:
**03.12.2025 Patentblatt 2025/49**

(21) Anmeldenummer: **22808789.6**

(22) Anmeldetag: **24.10.2022**

(51) Internationale Patentklassifikation (IPC):
*H01S 5/11* (2021.01)    *H01S 5/185* (2021.01)
*H01S 5/187* (2006.01)    *H01S 5/02* (2006.01)
*H01S 5/042* (2006.01)    *H01S 5/20* (2006.01)
*H01S 5/34* (2006.01)

(52) Gemeinsame Patentklassifikation (CPC):
**H01S 5/11; H01S 5/0217; H01S 5/0422;
H01S 5/0424; H01S 5/185;** H01S 5/0215;
H01S 5/0234; H01S 5/04254; H01S 5/04256;
H01S 5/04257; H01S 5/2027; H01S 5/2031;
H01S 5/341

(86) Internationale Anmeldenummer:
**PCT/EP2022/079570**

(87) Internationale Veröffentlichungsnummer:
**WO 2023/110203 (22.06.2023 Gazette 2023/25)**

(54) **OBERFLÄCHENEMITTIERENDER PHOTONISCHER-KRISTALL-LASER, OPTOELEKTRONISCHES SYSTEM UND VERFAHREN ZUR HERSTELLUNG EINES OBERFLÄCHENEMITTIERENDEN PHOTONISCHER-KRISTALL-LASERS**

SURFACE-EMITTING PHOTONIC CRYSTAL LASER, OPTOELECTRONIC SYSTEM, AND METHOD FOR PRODUCING A SURFACE-EMITTING PHOTONIC CRYSTAL LASER

LASER À CRISTAL PHOTONIQUE À ÉMISSION PAR LA SURFACE, SYSTÈME OPTOÉLECTRONIQUE ET PROCÉDÉ DE PRODUCTION D'UN LASER À CRISTAL PHOTONIQUE À ÉMISSION PAR LA SURFACE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **14.12.2021 DE 102021214311**

(43) Veröffentlichungstag der Anmeldung:
**23.10.2024 Patentblatt 2024/43**

(73) Patentinhaber: **ams-OSRAM International GmbH 93055 Regensberg (DE)**

(72) Erfinder: **BEHRINGER, Martin 93049 Regensburg (DE)**

(74) Vertreter: **Impuls legal PartG mbB Goethestraße 21 80336 München (DE)**

(56) Entgegenhaltungen:
**US-A1- 2005 029 536    US-A1- 2020 036 163
US-A1- 2021 184 431**

## Beschreibung

Strukturen, die durch die periodische Modulation des Brechungsindexes des verwendeten Mediums gebildet werden, werden als photonische Kristalle (engl.: "photonic crystal") bezeichnet. Ein oberflächenemittierender Photonischer-Kristall-Laser (engl.: "Photonic Crystal Surface Emitting Laser", PCSEL), im Folgenden bisweilen kurz Laser oder PCSEL genannt, weist eine aktive Schicht auf, die unter Anlegen eines Treiberstroms elektromagnetische Strahlung emittiert. Auf beiden Seiten der aktiven Schicht können dotierte Schichten, insbesondere Wellenleiterschichten und Mantelschichten, angeordnet sein. Weiterhin können sich auf beiden Seiten der aktiven Schicht elektrische Kontakte befinden, wobei zumindest ein elektrischer Kontakt strukturiert wird, um elektromagnetische Strahlung über die entsprechend strukturierte Fläche auszukoppeln. Dieser Aufbau kann zu inhomogener Stromeinprägung und/oder Abschattungen führen. Alternativ, um die aktive Schicht von nur einer Seite aus zu kontaktieren, können Durchkontaktierungen (Vias) durch die Wellenleiterschicht hindurch vorgesehen sein. Die Strahlqualität des Lasers kann hierbei aufgrund von Absorption wegen Dotierstoffen, Licht-Streuung an Vias und Filamentierung der Welle im Wellenleiter degradieren.

Es wird auf den folgenden Stand der Technik verwiesen:

> US 2021/184431 A1 (NODA) 17. Juni 2021;
> US 2020/036163 A1 (NISHIOKA) 30. Januar 2020;
> US 2005/029536 A1 (SUGITATSU) 10. Februar 2005.

Zumindest eine Aufgabe von bestimmten Ausführungsformen ist es, einen oberflächenemittierenden Photonischer-Kristall-Laser mit hoher Strahlqualität anzugeben. Eine weitere Aufgabe von bestimmten Ausführungsformen ist es, ein optoelektronisches System anzugeben, das einen solchen PCSEL aufweist. Außerdem ist es eine Aufgabe von bestimmten Ausführungsformen, ein Verfahren zur Herstellung eines solchen PCSELs anzugeben.

Diese Aufgaben werden durch Gegenstände gemäß den unabhängigen Patentansprüchen gelöst. Vorteilhafte Ausführungsformen und Weiterbildungen der Gegenstände sind in den abhängigen Ansprüchen gekennzeichnet und gehen weiterhin aus der nachfolgenden Beschreibung und den Zeichnungen hervor.

Gemäß zumindest einer Ausführungsform weist ein oberflächenemittierender Photonischer-Kristall-Laser, PCSEL, eine aktive Schicht zur Generierung elektromagnetischer Strahlung durch Ladungsträgerrekombination auf. Elektromagnetischer Strahlung kann im Folgenden "Strahlung" oder "Licht" genannt werden. Strahlung oder Licht kann insbesondere elektromagnetische Strahlung mit einer oder mehreren Wellenlängen oder Wellenlängenbereichen bezeichnen. Die aktive Schicht weist eine erste Hauptfläche und eine der ersten Hauptfläche gegenüberliegende zweite Hauptfläche auf. Die aktive Schicht besitzt eine Haupterstreckungsebene, die in lateralen Richtungen verläuft. Die erste und die zweite Hauptfläche verlaufen parallel zu den lateralen Richtungen. In einer zu den lateralen Richtungen senkrecht stehenden transversalen Richtung weist die aktive Schicht eine Dicke auf.

Gemäß zumindest einer Ausführungsform weist der Laser weiterhin eine erste Wellenleiterschicht auf, die auf der ersten Hauptfläche der aktiven Schicht angeordnet ist, und eine zweite Wellenleiterschicht, die auf der zweiten Hauptfläche der aktiven Schicht angeordnet ist. Mit anderen Worten ist die aktive Schicht zwischen der ersten und der zweiten Wellenleiterschicht angeordnet. Die von der aktiven Schicht generierte elektromagnetische Strahlung wird in der ersten und der zweiten Wellenleiterschicht geführt. Die erste und die zweite Wellenleiterschicht bilden einen Wellenleiter, in dem die aktive Schicht eingebettet ist. Eine optische Welle wird im Wellenleiter in einer lateralen Richtung geführt.

Gemäß zumindest einer Ausführungsform weist die zweite Wellenleiterschicht zueinander periodisch angeordnete Bereiche und weitere Bereiche auf. Ein Brechungsindex der Bereiche unterscheidet sich von einem Brechungsindex der weiteren Bereiche. Die Bereiche und die weiteren Bereiche bilden somit einen photonischen Kristall. Insbesondere bilden die Bereiche und die weiteren Bereiche einen 2-dimensionalen (2D) photonischen Kristall. Der photonische Kristall ist dazu ausgebildet, die von der aktiven Schicht generierte elektromagnetische Strahlung zu beeinflussen. Insbesondere streut der photonische Kristall die Strahlung in die transversale Richtung. Beispielsweise formt ein Material der zweiten Wellenleiterschicht, insbesondere ein Halbleitermaterial, die Bereiche der zweiten Wellenleiterschicht. Die weiteren Bereiche können durch ein weiteres Material der zweiten Wellenleiterschicht definiert sein. Zum Beispiel umfasst das weitere Material ein Oxid, Luft oder ein Gas. Insbesondere besitzen die weiteren Bereiche einen deutlich geringeren Brechungsindex als das entsprechend verwendete Halbleitermaterial der zweiten Wellenleiterschicht. Die Bereiche und die weiteren Bereiche sind zueinander regelmäßig angeordnet. Das kann bedeuten, dass die weiteren Bereiche matrixförmig angeordnet sind oder sich - in einer Aufsicht - auf Schnittpunkten eines Gitters befinden. Hierbei kann es sich um ein schiefwinkliges, rechtwinkliges, zentriertrechteckiges, hexagonales oder quadratisches Gitter handeln. Das Gitter kann aus einer Basis bestehen, die aus mehreren Elementen besteht. Eine Gitterperiode kann so gewählt werden, dass sie mit einer Wellenlänge der von der aktiven Schicht generierten Strahlung im Wesentlichen übereinstimmt, oder mit einem Vielfachen dieser Wellenlänge im Wesentlichen übereinstimmt. Auf diese Weise ist die Bragg-Bedingung erfüllt, um eine 2D-Rückkopplung in der Ebene des photonischen Kristalls und eine Lichtemission senkrecht dazu zu erreichen.

Hierbei wird die Gitterperiode von den periodisch angeordneten Bereichen bzw. weiteren Bereichen definiert. In der zweiten Wellenleiterschicht ist die Wellenlänge der elektromagnetischen Strahlung abhängig von einem effektiven Brechungsindex, wobei

$$\lambda_o = \lambda_G \cdot n_{eff}$$

gilt, mit der Vakuum-Wellenlänge $\lambda_o$, der Wellenlänge in der zweiten Wellenleiterschicht $\lambda_G$ und dem effektivem Brechungsindex $n_{eff}$. Der effektive Brechungsindex der zweiten Wellenleiterschicht basiert auf den Brechungsindices der Bereiche und weiteren Bereiche, und auf deren Anteile in der zweiten Wellenleiterschicht. Das bedeutet, dass die Wahl eines Durchmessers der weiteren Bereiche die Wellenlänge in der zweiten Wellenleiterschicht beeinflusst. Das Verhältnis zwischen dem Durchmesser der weiteren Bereiche und der Gitterperiode kann möglichst klein gewählt werden, um einen Gütefaktor (Q-Faktor) der Emission zu verbessern. Ein hoher Q-Faktor verringert die Lasing-Schwelle des Lasers und führt zu einer Wellenlängen-Modenresonanz mit geringer Dämpfung. Andererseits verbessert ein größerer Durchmesser der weiteren Bereiche den Brechungsindexkontrast des photonischen Kristalls.

Elektromagnetische Strahlung, die sich durch den photonischen Kristall bewegt, wird an den Grenzflächen zwischen den Bereichen und den weiteren Bereichen, d.h. allgemein an Ungleichförmigkeiten, gestreut. Gestreute Wellen der elektromagnetischen Strahlung können miteinander und mit der ursprünglichen Welle konstruktiv oder destruktiv interferieren. Da diese Ungleichförmigkeiten, d.h. in diesem Fall die Bereiche und die weiteren Bereiche, periodisch verteilt sind, kann möglicherweise vollständige destruktive Interferenz oder die Bildung von kohärenter Strahlung erreicht werden. Elektromagnetische Strahlung kann sich abhängig von ihrer Frequenz und der Gitterperiodizität des photonischen Kristalls nur in bestimmte Richtungen des Gitters ausbreiten und wird reflektiert, wenn sie in sogenannte verbotene Richtungen gelenkt wird. Hierbei kann es zur Bildung einer stehenden Welle kommen, wobei die Strahlung wiederholt an verschiedenen Ungleichförmigkeiten gestreut wird und konstruktiv in sich selbst interferiert. Die stehende Welle wird durch mehrere Bragg-Beugungen gebildet.

Photonische Kristalle, insbesondere 2D photonische Kristalle, können vorteilhaft bei Laseranordnungen zum Einsatz kommen, wodurch ein sogenannter oberflächenemittierender Photonischer-Kristall-Laser, PCSEL, gebildet werden kann. Die stimulierte Lichtemission wird durch Kopplung der Moden des photonischen Kristalls mit der aktiven Schicht des Lasers erreicht. Hierbei kommt es zu dem oben beschriebenen Rückkopplungseffekt innerhalb der Kristallebene. Durch Bragg-Beugung erster Ordnung wird kohärente Strahlung auch senkrecht zur Kristalloberfläche emittiert. Es ist auch möglich, dass kohärente Strahlung in einem zur Kristalloberfläche vom 90°- Winkel verschiedenen Winkel emittiert wird. Die emittierte Strahlung kann sich vor allem durch ihre Monomodigkeit, ihr enges Abstrahlprofil und ihre hohe Ausgangsleistung über eine große Abstrahlfläche auszeichnen.

Gemäß zumindest einer Ausführungsform weist der Laser weiterhin eine erste Mantelschicht (engl.: cladding) auf, die auf der ersten Wellenleiterschicht angeordnet ist. Mit anderen Worten ist die erste Wellenleiterschicht zwischen der aktiven Schicht und der ersten Mantelschicht angeordnet. Mantelschichten können auch als Cladding-Schichten bezeichnet werden. Die erste Mantelschicht kann dazu ausgebildet sein, die in lateraler Richtung geführte optische Welle im Wellenleiter zu halten. Dazu kann die erste Mantelschicht einen niedrigeren Brechungsindex als die erste Wellenleiterschicht aufweisen, so dass die laterale optische Welle an der Grenzfläche zwischen erster Wellenleiterschicht und erster Mantelschicht reflektiert, insbesondere totalreflektiert. Optional weist der Laser weiterhin eine zweite Mantelschicht mit entsprechenden Eigenschaften (insbesondere niedrigerem Brechungsindex als die zweite Wellenleiterschicht) auf, die auf der zweiten Wellenleiterschicht angeordnet ist. Mit anderen Worten ist die zweite Wellenleiterschicht zwischen der aktiven Schicht und der optionalen zweiten Mantelschicht angeordnet. Alternativ weist der Laser keine zweite Mantelschicht auf. In diesem Fall wird die optische Welle an der Grenzfläche zwischen der zweiten Wellenleiterschicht und der Umgebung, z.B. Luft, reflektiert. Luft besitzt im Allgemeinen einen sehr niedrigen Brechungsindex ($n \approx 1$) und ermöglicht somit Totalreflexion. Ohne zweite Mantelschicht können folglich die Herstellungskosten des Lasers reduziert werden.

Gemäß zumindest einer Ausführungsform weist die erste Mantelschicht zumindest einen p-Anschlussbereich zur Injektion von elektrisch positiven Ladungsträgern in die aktive Schicht auf. Die erste Mantelschicht weist ferner zumindest einen n-Anschlussbereich zur Injektion elektrisch negativer Ladungsträger in die aktive Schicht auf. Elektrisch positive Ladungsträger können auch als Löcher bezeichnet werden. Elektrisch negative Ladungsträger können auch als Elektronen bezeichnet werden. Elektronen und Löcher rekombinieren in der aktiven Schicht unter Aussendung elektromagnetischer Strahlung. Die erste Mantelschicht kann einen oder mehr als einen p-Anschlussbereich aufweisen. Die erste Mantelschicht kann einen oder mehr als einen n-Anschlussbereich aufweisen. Alle hier und im Folgenden gemachten Angaben zu einem p-Anschlussbereich bzw. n-Anschlussbereich können für alle weiteren p- bzw. n-Anschlussbereiche entsprechend gelten. Die Anschlussbereiche (n- und/oder p-) können voneinander getrennte und beabstandete Bereiche der ersten Mantelschicht sein. Alternativ können die Anschlussbereiche aber auch nicht überlappende Bereiche der ersten Mantelschicht sein. Die Anschlussbereiche (n- und/oder p-) können beispielsweise durch Implantation oder Diffusion von Dotieratomen des n-Typs bzw. des p-Typs hergestellt sein. Es ist auch möglich, dass entsprechende Dotieratome durch Zugabe bestimmter Prozessgase bereits beim Aufwachsen der ersten Mantelschicht in die erste Mantelschicht eingebracht werden. Beispielsweise ist die erste Mantelschicht eine n-dotierte, undotierte oder intrinsisch dotierte Schicht, wobei durch p-Implantation (bzw. Gegenimplantation) die p-Anschlussbereiche geformt werden. Die übrigen Bereiche der ersten Mantelschicht können in diesem Beispiel die n-Anschlussbereiche formen. Alternativ ist die erste Mantelschicht eine p-dotierte, undotierte oder intrinsisch dotierte Schicht, wobei durch n-Implantation, d.h. Implantation eines Dotierstoffes des n-Typs, (bzw. Gegenimplantation) die n-Anschlussbereiche geformt werden und wobei die übrigen Bereiche der ersten Mantelschicht die p-Anschlussbereiche formen. Der Ladungsträgertransport über die n-Anschlussbereiche und/oder p-Anschlussbereiche zur aktiven Schicht erfolgt insbesondere aufgrund von Diffusion. Dass kann bedeuten, dass Ladungsträger durch die erste Wellenleiterschicht hindurch diffundieren. Die positiven Ladungsträger und die negativen Ladungsträger werden von der gleichen Seite, bezogen auf die Wachstumsrichtung, in die aktive Schicht injiziert.

Die aktive Schicht, die erste und zweite Wellenleiterschicht und/oder die erste und zweite (falls vorhanden) Mantelschicht können bevorzugt ein Halbleitermaterial umfassen. Bei dem Halbleitermaterial handelt es sich zum Beispiel um ein III-V-Verbindungshalbleitermaterial. Bei dem Halbleitermaterial handelt es sich zum Beispiel um ein Nitrid-Verbindungshalbleitermaterial, wie $Al_nIn_{1-n-m}Ga_mN$, oder um ein Phosphid-Verbindungshalbleitermaterial, wie $Al_nIn_{1-n-m}Ga_mP$, oder um ein Arsenid-Verbindungshalbleitermaterial, wie $Al_nIn_{1-n-m}Ga_mAs$ oder $Al_nIn_{1-n-m}Ga_mAsP$, oder um ein Antimonid-Verbindungshalbleitermaterial, wie $Al_nIn_{1-n-m}Ga_mSb$, oder auch AlInGaAsN oder um eine Mischung der vorgenannten Verbindungshalbleitermaterialien, wobei jeweils $0 \le n \le 1$, $0 \le m \le 1$ und $m + n \le 1$ ist. Dabei kann eine halbleitende Schicht Dotierstoffe sowie zusätzliche Bestandteile aufweisen. Der Einfachheit halber sind jedoch nur die wesentlichen Bestandteile des Kristallgitters der halbleitenden Schicht, also Al, As, Ga, In, N, P oder Sb angegeben, auch wenn diese teilweise durch geringe Mengen weiterer Stoffe ersetzt und/oder ergänzt sein können. Die aktive Schicht, die erste und zweite Wellenleiterschicht und/oder die erste und zweite (falls vorhanden) Mantelschicht können epitaktisch aufgewachsen sein. Insbesondere können die aktive Schicht, die erste und zweite Wellenleiterschicht, und die erste und zweite Mantelschicht in einem kontinuierlichen Epitaxie-Prozess aufgewachsen sein. Durch den ununterbrochenen Epitaxie-Prozess kann die Materialqualität erhöht werden, da Möglichkeiten einer Kontamination mit Fremdatomen und Kristalldefekte reduziert werden. Es ist aber auch möglich, dass die erste und/oder die zweite Mantelschicht nicht epitaktisch aufgebracht werden. Es ist ebenso möglich, dass die zweite Wellenleiterschicht nicht epitaktisch aufgebracht wird. Dies wird ermöglicht, da Materialanforderungen an die zweite Wellenleiterschicht und/oder die zweite Mantelschicht hinsichtlich elektrischer Eigenschaften geringer sind (über diese Schichten wird erfindungsgemäß kein Strom geführt).

Der PCSEL zeichnet sich insbesondere dadurch aus, dass Ladungsträger von nur einer Seite, nämlich über die erste Mantelschicht und die erste Wellenleiterschicht, in die aktive Schicht injiziert werden. Dadurch wird eine Abschattung durch einen Oberseitenkontakt auf der Seite der Strahlungsauskopplung vermieden, was besonders bei großen Laser-Durchmessern und hohen Treiberströmen gravierend sein kann. Der PCSEL kann folglich beliebig groß skaliert werden. Damit können auch beliebig kleine Divergenzwinkel der ausgekoppelten Strahlung erreicht werden. Die Anschlussbereiche und mögliche elektrische Kontakte, über die die Ladungsträger in die aktive Schicht injiziert werden, können beliebig über die erste Mantelfläche verteilt werden, um eine Stromverteilung zu verbessern und höhere Leistungen des Lasers zu erzielen. Es werden keine Ladungsträger über die zweite Wellenleiterschicht in die aktive Schicht injiziert. Das bedeutet, dass die den Anschlussbereichen abgewandte Seite der Struktur, insbesondere die zweite Wellenleiterschicht, nicht notwendigerweise dotiert sein muss. Die Effizienz des Lasers kann damit erhöht werden, da eine Absorption der optischen Welle an Dotierstoffen vermieden wird.

Gemäß zumindest einer Ausführungsform weist ein oberflächenemittierender Photonischer-Kristall-Laser eine aktive Schicht zur Generierung elektromagnetischer Strahlung durch Ladungsträger Rekombination auf, wobei die aktive Schicht eine erste Hauptfläche und eine der ersten Hauptfläche gegenüberliegende zweite Hauptfläche aufweist. Der Laser weist ferner eine auf der ersten Hauptfläche angeordnete erste Wellenleiterschicht auf. Der Laser weist ferner eine auf der zweiten Hauptfläche angeordnete zweite Wellenleiterschicht auf, die zueinander periodisch angeordnete Bereiche und weitere Bereiche aufweist, wobei sich ein Brechungsindex die Bereiche von einem Brechungsindex der weiteren Bereiche unterscheidet, und wobei die Bereiche und die weiteren Bereiche einen photonischen Kristall bilden. Der Laser weist weiterhin eine auf der ersten Wellenleiterschicht angeordnete erste Mantelschicht auf, die zumindest einen p-Anschlussbereich zur Injektion von elektrisch positiven Ladungsträgern in die aktive Schicht und zumindest einen n-Anschlussbereich zur Injektion von elektrisch negativen Ladungsträgern in die aktive Schicht aufweist.

Gemäß zumindest einer Ausführungsform weist die zweite Wellenleiterschicht ein Material auf, welches die Bereiche der zweiten Wellenleiterschicht definiert. Gemäß zumindest einer Ausführungsform weist, wie oben ausgeführt, die zweite Wellenleiterschicht ein Halbleitermaterial auf, insbesondere ein III-V-Verbindungshalbleitermaterial. Es ist aber auch möglich dass die zweite Wellenleiterschicht ein anderes Material bzw. Materialsystem aufweist. Insbesondere kann sich das Material bzw. Materialsystem der zweiten Wellenleiterschicht vom Material bzw. Materialsystem der übrigen Schichten (aktive Schicht, erste Wellenleiterschicht, erste Mantelschicht) unterscheiden. In Laserstrukturen kann für die darin enthaltenen Schichten das gleiche Materialsystem verwendet werden, um Kristalldefekte zu reduzieren und damit die elektrischen Eigenschaften, wie elektrische Leitfähigkeit, zu verbessern. Da die vorliegenden Ausführungsbeispiele darauf basieren, dass ein Treiberstrom nur über die erste Wellenleiterschicht in die aktive Schicht injiziert wird, sind die Materialanforderungen an die zweite Wellenleiterschicht hinsichtlich elektrischer Eigenschaften geringer. Stattdessen kann ein Material hinsichtlich optischer Eigenschaften, wie Brechungsindex und/oder Absorption, ausgewählt werden. Die zweite Wellenleiterschicht kann folglich andere Materialen, wie zum Beispiel Silizium, Magnesium und/oder Fluorid-Verbindungen, aufweisen.

Gemäß zumindest einer Ausführungsform sind die weiteren Bereiche der zweiten Wellenleiterschicht durch Ausnehmungen der zweiten Wellenleiterschicht definiert. Das kann bedeuten, dass die zweite Wellenleiterschicht strukturiert ist, wobei Gebiete, in denen das oben genannte Material der zweiten Wellenleiterschicht entfernt wurde, die weiteren Bereiche der zweiten Wellenleiterschicht bilden. Die weiteren Bereiche können Luft oder ein Gas aufweisen. Alternativ sind die Ausnehmungen mit einem weiteren Material, z.B. einem Oxid, gefüllt. Somit können die weiteren Bereiche einen niedrigeren Brechungsindex aufweisen als die Bereiche der zweiten Wellenleiterschicht. Die Bereiche der zweiten Wellenleiterschicht können auch als Zonen mit hohem Brechungsindex bezeichnet werden. Die weiteren Bereiche der zweiten Wellenleiterschicht können auch als Zonen mit niedrigem Brechungsindex bezeichnet werden.

Gemäß zumindest einer Ausführungsform werden die Ausnehmungen der zweiten Wellenleiterschicht durch Gräben oder Löcher in der zweiten Wellenleiterschicht gebildet. Die Gräben erstrecken sich von einer der aktiven Schicht abgewandten Oberfläche der zweiten Wellenleiterschicht bis in die zweite Wellenleiterschicht hinein. Die Gräben sind in dezidierte Gebiete der zweiten Wellenleiterschicht eingebracht. Gemäß einer Ausführungsform liegt ein Durchmesser der Gräben im Nanometer-Bereich. Beispielsweise besitzen die Gräben einen Durchmesser von wenigstens 5 nm und höchstens 1000 nm. Bevorzugt besitzen die Gräben einen Durchmesser von wenigstens 10 nm und höchstens 50 nm. Die Gräben können auch als Löcher oder Nano-Löcher bezeichnet werden, und umgekehrt. Die Form der Gräben kann zylindrisch sein, d.h. in der Aufsicht können die Gräben ein kreisförmiges oder elliptisches Profil haben. Es ist aber auch möglich, dass die Gräben ein anderes Profil, z.B. polygonales, insbesondere drei- oder viereckiges, Profil aufweisen. Es kann ferner sein, dass wenigstens zwei Gräben unterschiedliche Profile aufweisen. Das Profil der Gräben wirkt sich auf ein Modenprofil des photonischen Kristalls aus. Beispielsweise können bestimmte Symmetrien zu sog. Leckmoden oder Nicht-Leckmoden (engl.: "leaky modes" bzw. "non-leaky modes") führen, und damit die Abstrahleffizienz der Laseranordnung beeinflussen. In der transversalen Richtung enden die Gräben in der zweiten Wellenleiterschicht. Das bedeutet, dass sich ein Grabenfuß in der zweiten Wellenleiterschicht befindet. Der Grabenfuß eines jeweiligen Grabens ist von der aktiven Schicht beabstandet. In transversaler Richtung (d.h. Aufwachsrichtung) kann eine Tiefe der Gräben 10-80%, 50-80% oder 70-80% der Dicke der zweiten Wellenschicht entsprechen. In anderen Worten können die Gräben die zweite Wellenleiterschicht bis zu 80% durchdringen. Das kann insbesondere bedeuten, dass ein Überlapp der optischen Welle mit den Gräben groß sein kann. Die Gräben sind zueinander regelmäßig angeordnet. Das kann bedeuten, dass die Gräben matrixförmig angeordnet sind oder sich - in der Aufsicht - auf Schnittpunkten eines Gitters befinden, wobei eine Gitterperiode so gewählt werden kann, dass sie mit einer Wellenlänge der von der aktiven Schicht generierten Strahlung, mit einem ganzzahligen Vielfachen der Wellenlänge, oder mit einem nicht-ganzzahligen Vielfachen der Wellenlänge übereinstimmt, wie oben beschrieben. Durch die Gräben kann ein photonischer Kristall effizient gebildet werden. Insbesondere ist kein Überwachsen (engl.: "Regrowth") nötig, da die Gräben am Ende eines Herstellungsverfahrens in die (undotierte) zweite Wellenleiterschicht eingebracht werden können. Zeitintensive und teure Prozessschritte können somit vermieden werden, was eine Massenproduktion deutlich einfacher macht. Da hierdurch die verwendeten Schichten durch einen ununterbrochenen Epitaxie-Prozess hergestellt werden können, kann außerdem die Materialqualität erhöht werden, da Möglichkeiten einer Kontamination mit Fremdatomen und Kristalldefekte reduziert werden.

Gemäß zumindest einer alternativen Ausführungsform sind die weiteren Bereiche in der zweiten Wellenleiterschicht eingebettet. Das kann insbesondere bedeuten, dass sich die weiteren Bereiche nicht bis zur Oberfläche der zweiten Wellenleiterschicht 15 erstrecken. Eine solche Anordnung kann beispielsweise mittels Regrowth-Verfahren hergestellt werden.

Gemäß zumindest einer Ausführungsform ist die erste Wellenleiterschicht undotiert oder intrinsisch dotiert. Undotiert oder intrinsisch dotiert meint hier zum Beispiel eine Dotierkonzentration von höchstens $1 \cdot 10^{16}$ $cm^{-3}$ oder höchstens $1 \cdot 10^{15}$ $cm^{-3}$. Die erste Wellenleiterschicht kann dünn ausgebildet sein, so dass Ladungsträger trotz geringer Dotierkonzentration der ersten Wellenleiterschicht durch diese hindurch diffundieren können, um in der aktiven Schicht zu rekombinieren. Eine Absorption der optischen Wellen an Dotierstoffen kann somit vermieden oder reduziert werden.

Alternativ weisen zumindest Bereiche der ersten Wellenleiterschicht eine p-Dotierung und/oder eine n-Dotierung auf. In diesem Fall beträgt die Dotierkonzentration dort bevorzugt höchstens $1\cdot10^{19}$ cm$^{-3}$ oder bei höchstens $1\cdot10^{18}$ cm$^{-3}$ oder bei höchstens $1\cdot10^{17}$ cm$^{-3}$. Entlang der lateralen Richtung können sich in der ersten Wellenleiterschicht Bereiche mit p-Dotierung mit undotierten Bereichen oder Bereichen mit n-Dotierung abwechseln. Die entsprechenden Bereiche können mit den p-Anschlussbereichen bzw. n-Anschlussbereichen der ersten Mantelschicht korrespondieren, d.h. an diesen ausgerichtet sein. Durch die Dotierung kann die Diffusion in Richtung der aktiven Schicht erleichtert werden.

Gemäß zumindest einer Ausführungsform ist die zweite Wellenleiterschicht undotiert oder intrinsisch dotiert. Wie oben ausgeführt kann undotiert oder intrinsisch dotiert hier zum Beispiel eine Dotierkonzentration von höchstens $1\cdot10^{16}$ cm$^{-3}$ oder höchstens $1\cdot10^{15}$ cm$^{-3}$ meinen. Die zweite Wellenleiterschicht führt keinen Treiberstrom. Eine Absorption der optischen Wellen an Dotierstoffen und nichtstrahlende Rekombination von Ladungsträgern in dieser Schicht kann somit vermieden oder reduziert werden. Das bedeutet, dass die Strahlqualität und das Leuchtbild der lateral laufenden optischen Welle verbessert werden. Störungen aufgrund von Ladungsträgerdichten werden reduziert und Filamente mit hoher Leuchtintensität vermieden. Mit anderen Worten wird der sogenannte $\alpha$-Faktor (auch engl.: "linewidth enhancement factor") verringert. Vergrößerte Spektralbreiten können aus einer Kopplung zwischen Intensität und Phasenrauschen resultieren, die durch die Abhängigkeit des Brechungsindex von der Ladungsträgerdichte im Halbleiter verursacht wird.

Gemäß zumindest einer Ausführungsform ist eine Dicke der ersten Wellenleiterschicht geringer als eine Dicke der zweiten Wellenleiterschicht. Dicke meint hier die Ausdehnung der entsprechenden Schicht in transversaler Richtung (Aufwachsrichtung). Alternativ ist die Dicke der ersten Wellenleiterschicht im Rahmen der Herstellungstoleranzen gleich der Dicke der zweiten Wellenleiterschicht. Es ist auch möglich, dass die Dicke der ersten Wellenleiterschicht größer ist als die Dicke der zweiten Wellenleiterschicht. Die erste Wellenleiterschicht und die zweite Wellenleiterschicht bilden zusammen einen Wellenleiter, in dem die aktive Schicht eingebettet ist. Der Wellenleiter kann eine Gesamtdicke von minimal $0,1$ $\mu$m und maximal $10$ $\mu$m haben. Alternativ beträgt die Gesamtdicke zwischen $0,5$ $\mu$m und $2$ $\mu$m. Wenn die Dicke der ersten Wellenleiterschicht mit der Dicke der zweiten Wellenleiterschicht übereinstimmt ist die Position der aktiven Schicht im Wellenleiter mittig, so dass ein symmetrisches Wellenleiterdesign realisiert ist. Andernfalls wird ein asymmetrisches Wellenleiterdesign realisiert, bei dem die Position der aktiven Schicht im Wellenleiter bei 10-90% hinsichtlich der Gesamtdicke des Wellenleiters liegen kann. Bevorzugt ist die Dicke der ersten Wellenleiterschicht geringer als die Dicke der zweiten Wellenleiterschicht. Beispielsweise ist die zweite Wellenleiterschicht 2- bis 5-mal dicker als die erste Wellenleiterschicht. In diesem Fall ist ein Abstand der aktiven Schicht zu einer der aktiven Schicht abgewandten Oberfläche der ersten Wellenleiterschicht (an der sich die erste Mantelschicht befindet) geringer als ein Abstand der aktiven Schicht zu einer der aktiven Schicht abgewandten Oberfläche der zweiten Wellenleiterschicht (an der sich die zweite Mantelschicht befinden kann). Auf diese Weise kann die Ladungsträgerinjektion vergrößert werden, da ein Diffusionsweg verringert wird. Des Weiteren befinden sich auf diese Weise große Teile der im Wellenleiter geführten optischen Welle in der zweiten Wellenleiterschicht, in der der photonische Kristall angeordnet ist. Insbesondere befindet sich ein Maximum der Intensitätsverteilung der Welle in der zweiten Wellenleiterschicht. Das bedeutet, dass der optische Kristall starken Einfluss auf die Welle nehmen kann.

Gemäß zumindest einer Ausführungsform weist der Laser weiterhin eine auf der zweiten Wellenleiterschicht angeordnete zweite Mantelschicht auf. Mit anderen Worten ist die zweite Wellenleiterschicht zwischen der aktiven Schicht und der zweiten Mantelschicht angeordnet. Die zweite Mantelschicht kann dazu ausgebildet sein, die in lateraler Richtung geführte optische Welle im Wellenleiter zu halten. Dazu kann die zweite Mantelschicht einen niedrigeren Brechungsindex als die zweite Wellenleiterschicht aufweisen, so dass die lateral laufende optische Welle an der Grenzfläche zwischen der zweiten Wellenleiterschicht und der zweiten Mantelschicht reflektiert, insbesondere totalreflektiert wird.

Gemäß zumindest einer Ausführungsform ist die zweite Mantelschicht undotiert oder intrinsisch dotiert. Die zweite Mantelschicht kann undotiert oder intrinsisch dotiert sein, da über die zweite Mantelschicht keine Ladungsträger transportiert werden. Auf diese Weise kann für die zweite Mantelschicht ein Material mit hoher Bandlücke - was einem kleinen Brechungsindex entspricht - ohne Rücksicht auf die Dotierbarkeit gewählt werden. Das kann bedeuten, dass sich ein Material oder Materialsystem der zweiten Mantelschicht von einem Material oder Materialsystem der ersten Mantelschicht unterscheidet.

Gemäß zumindest einer Ausführungsform sind die Ausnehmungen der zweiten Wellenleiterschicht durch Gräben in der zweiten Wellenleiterschicht gebildet, die sich von einer der zweiten Wellenleiterschicht abgewandten Oberfläche der zweiten Mantelschicht bis in die zweite Wellenleiterschicht hinein erstrecken. Das kann bedeuten, dass mit Einbringen der Gräben, wie oben ausgeführt, auch die zweite Mantelschicht strukturiert wird. Die zweite Mantelschicht kann aufgrund der flexiblen Materialwahl dünn sein, insbesondere dünner als die erste Mantelschicht. Dadurch lässt sich die zweite Mantelschicht und die darunter liegende zweite Wellenleiterschicht leicht strukturieren, was insbesondere bedeutet, dass das Profil der eingebrachten Gräben strukturtreu ausgebildet werden kann.

Gemäß zumindest einer Ausführungsform bildet die aktive Schicht zumindest einen Quantentopf, der dazu vorgesehen und ausgebildet ist, unter Anlegen eines Treiberstroms elektromagnetische Strahlung einer vorbestimmten Wellenlänge zu imitieren. Dazu umfasst die aktive Schicht bevorzugt zumindest einen Quantentopf in Form eines 2D-Quantentopfs (Quantentrog, engl.: "quantum well") oder 1D-Quantentopfs (Quantendraht, engl.: "quantum wire) oder 0D-Quantentopfs (Quantenpunkt, engl.: "quantum dot"). Beispielsweise umfasst die Rekombinationsschicht eine Mehrzahl von in transversaler Richtung übereinander angeordneten 2D-Quantentöpfen, die jeweils durch eine Barriereschicht getrennt sind. Das kann bedeuten, dass die aktive Schicht eine Mehrzahl von Halbleiterschichten umfassen kann, die mindestens einen Quantentopf bilden. Ein 2D-Quantentopf kann durch eine dünne Zwischenschicht eines ersten Materials, z.B. etwa 4-5 nm dick, gebildet werden, die von Barriereschichten eines zweiten Materials, z.B. etwa 3-10 nm dick, umgeben ist. Die Barriere-Schichten weisen eine größere Bandlücke als die Zwischenschicht auf. Dies erzeugt ein Potenzialgefälle im Leitungs- und Valenzband zwischen den beiden Materialgruppen, wobei ein Potential-Minimum in der Zwischenschicht gebildet wird. Aufgrund der Quantisierung des Systems können Ladungsträger in der Zwischenschicht nur diskrete Energiewerte annehmen. In einer Ausführungsform bildet die aktive Schicht mindestens einen Quantentopf und höchstens hundert Quantentöpfe. Bevorzugt bildet die aktive Schicht zwischen einschließlich zwei und einschließlich zehn Quantentöpfe. Die aktive Schicht kann auch als "multi quantum well", MQW, bezeichnet werden. Eine in Wachstumsrichtung (transversale Richtung) erste und eine letzte Schicht des von der aktiven Schicht gebildeten Schichtstapels können dazu vorgesehen und ausgebildet sein, Ladungsträger in der aktiven Schicht einzuschließen, d.h. daran zu hindern, die aktive Schicht zu verlassen (engl.: "confinement"). Das bedeutet, dass die erste und die letzte Schicht als sog. "confinement layers" mit größerer Bandlücke ausgeführt sein können. Alternativ kann die aktive Schicht eine Mehrzahl von Quantenpunkten aufweisen. Die Quantenpunkte können in einer Ebene parallel zur Haupterstreckungsebene der aktiven Schicht nebeneinander angeordnet sein. Auch kann die aktive Schicht mehrere übereinandergestapelte Ebenen parallel zur Haupterstreckungsebene der aktiven Schicht mit jeweils einer Mehrzahl von Quantenpunkten innerhalb dieser Ebenen aufweisen. Die verschiedenen Ebenen von Quantenpunkten sind dann bevorzugt durch Barriereschichten voneinander getrennt. Quantentöpfe ermöglichen Laserausstrahlung bei dezidierten Wellenlängen aus einem breiten Spektralbereich bei gleichzeitig hohen Leistungen und kleinem Schwellenstrom.

Gemäß zumindest einer Ausführungsform steht eine Abstrahlrichtung des Lasers senkrecht auf einer Haupterstreckungsebene der zweiten Wellenleiterschicht. Elektromagnetische Strahlung wird über eine der aktiven Schicht abgewandten Oberfläche der zweiten Wellenleiterschicht ausgekoppelt. Die von der aktiven Schicht generierte Strahlung wird von dem photonischen Kristall derart beeinflusst, dass in ihm durch Beugungseffekte elektromagnetische Felder konstruktiv oder destruktiv miteinander interferieren. Hierbei kann es zur Bildung einer stehenden Welle innerhalb des Wellenleiters kommen. Durch Bragg-Beugung erster Ordnung wird kohärentes Licht auch senkrecht zum photonischen Kristall, also senkrecht zur Haupterstreckungsebene des Wellenleiters, emittiert. Das emittierte Licht kann über die der aktiven Schicht gegenüberliegende Oberfläche der zweiten Wellenleiterschicht bzw. die Oberfläche der zweiten Mantelschicht ausgekoppelt werden. Es ist auch möglich, dass das Licht unter einem von 90° verschiedenen Winkel, also nicht notwendigerweise senkrecht zur Haupterstreckungsebene des Wellenleiters, ausgekoppelt wird.

Gemäß zumindest einer Ausführungsform weist der Laser weiterhin eine auf oder über der ersten Mantelschicht angeordnete reflektierende Schicht auf. Die reflektierende Schicht kann eine dezidierte Schicht auf oder über der ersten Mantelschicht sein. Gemäß einer Ausführungsform wird die reflektierende Schicht von elektrischen Kontaktelementen gebildet, über die die Anschlusselemente der ersten Mantelschicht angeschlossen werden. Beispielsweise weist die reflektierende Schicht ein Metall auf, wie Gold (Ag), Titan (Ti), Silber (Ag), Platin (Pt) und/oder Palladium (Pd). Die reflektierende Schicht bewirkt, dass die vom photonischen Kristall senkrecht in Richtung der erste Mantelschicht gestreute elektromagnetische Strahlung zurück reflektiert wird, damit die elektromagnetische Strahlung vorzugsweise über die der ersten Mantelfläche gegenüberliegende zweite Mantelfläche ausgekoppelt wird.

Gemäß zumindest einer Ausführungsform weist die erste Mantelschicht eine Mehrzahl von einzelnen und unabhängig ansteuerbaren p-Anschlussbereichen und/oder eine Mehrzahl von einzelnen und unabhängig ansteuerbaren n-Anschlussbereichen auf. Die ersten bzw. zweiten Anschlusselemente sind einzeln und unabhängig voneinander elektrisch kontaktierbar beziehungsweise bestrombar. Das heißt, die ersten bzw. zweiten Anschlusselemente sind nicht unmittelbar elektrisch leitend miteinander verbunden. Durch die einzelnen und unabhängig ansteuerbaren Anschlussbereiche (p- und/oder n-) lässt sich eine inhomogene Stromeinprägung erreichen, d.h. einzelne Anschlussbereiche können mit unterschiedlichen Strömen bedient werden. Das bedeutet, dass sich eine Stromdichte in lateralen Richtungen variieren lässt. Die Stromdichte kann angepasst werden, um bestimmte optische Moden anzuregen.

Gemäß zumindest einer Ausführungsform sind, in einer Aufsicht betrachtet, die p-Anschlussbereiche und die n-Anschlussbereiche schachbrettartig angeordnet. Das kann bedeuten, dass in lateralen Richtungen die n-Anschlussbereiche und die p-Anschlussbereiche alternieren. Es ist also zwischen je zwei n-Anschlusselementen ein p-Anschlusselement angeordnet, und umgekehrt. Auf diese Weise kann die Stromeinprägung flexibel gestaltet werden.

Gemäß zumindest einer Ausführungsform sind, in der Aufsicht betrachtet, der zumindest eine p-Anschlussbereich und der zumindest eine n-Anschlussbereich als konzentrische Ringe ausgebildet. Weist der Laser eine Mehrzahl von n-Anschlussbereichen und eine Mehrzahl von p-Anschlusselementen auf, können die Ringe bildenden Anschlussbereiche alternierend angeordnet sein. In diesem Fall kann beispielsweise ein erster n-Anschlussbereich in der Aufsicht den innersten Ring bzw. Kreis bilden und von einem ersten p-Anschlussbereich ringförmig umgeben sein. Ein zweiter n-Anschlussbereich kann den ersten p-Anschlussbereich ringförmig umgeben, und ein zweiter p-Anschlussbereich kann den zweiten n-Anschlussbereich ringförmig umgeben, usw. Die Ringe haben demnach variierende Durchmesser. Alternativ kann ein innerster Ring auch von einem p-Anschlussbereich gebildet werden. Auf diese Weise kann die Stromeinprägung flexibel gestaltet werden, um bestimmte optische Moden anzuregen.

Gemäß zumindest einer Ausführungsform weist der Laser zumindest ein erstes elektrisches Kontaktelement auf. Auf jedem p-Anschlussbereich ist ein jeweiliges erstes elektrisches Kontaktelement angeordnet und diesem zugeordnet. Gemäß zumindest einer Ausführungsform weist der Laser zumindest ein zweites elektrisches Kontaktelement auf. Auf jedem n-Anschlussbereich ist ein jeweiliges zweites elektrisches Kontaktelement angeordnet und diesem zugeordnet. Die ersten und zweiten Kontaktelemente können ein hochdotiertes Halbleitermaterial und/oder ein Metall aufweisen. Die ersten und zweiten elektrischen Kontaktelemente umfassen bevorzugt ein Metall, wie Ag, Pt, Au, Pd, Ti, oder bestehen daraus. Alternativ oder zusätzlich können die ersten und zweiten elektrischen Kontaktelemente auch ein transparent leitfähiges Oxid, kurz TCO, wie Indiumzinnoxid, kurz ITO, oder Zinkoxid umfassen oder daraus bestehen. Die ersten und zweiten elektrischen Kontaktelemente können gleichzeitig auch die reflektierende Schicht formen, wie oben ausgeführt, insbesondere dann, wenn sie ein Metall umfassen. Insbesondere sind die ersten und zweiten elektrischen Kontaktelemente voneinander beabstandet und voneinander getrennt. Da jedem Anschlussbereich ein Kontaktelement zugeordnet sein kann, kann der Laser eine Mehrzahl von elektrischen Kontaktelementen aufweisen, insbesondere so viele elektrische Kontaktelemente wie Anschlussbereiche. Der Laser umfasst zum Beispiel zumindest vier oder zumindest zehn oder zumindest 100 erste elektrische Kontaktelemente und/oder zumindest vier oder zumindest zehn oder zumindest 100 zweite elektrische Kontaktelemente. Die ersten und zweiten elektrischen Kontaktelemente verbinden die Anschlussbereiche (p- bzw. n-Anschlussbereiche) mit einer Quelle für Ladungsträger. Auf diese Weise können Elektronen über die zweiten elektrischen Kontaktelemente und die n-Anschlussbereiche zu der aktiven Schicht geführt werden, während Löcher über die ersten elektrischen Kontaktelemente und die p-Anschlussbereiche zu der aktiven Schicht geführt werden können.

Gemäß zumindest einer Ausführungsform ist ein optoelektronisches System angegeben. Das optoelektronische System weist einen oberflächenemittierenden Photonischer-Kristall-Laser gemäß den oben ausgeführten Ausführungsformen auf. Das bedeutet, dass alle für den PCSEL offenbarten Merkmale auch für das optoelektronische System offenbart werden und umgekehrt. Der PCSEL kann in das optoelektronische System integriert sein. Beispielsweise handelt es sich bei dem optoelektronischen System um ein LIDAR-System. Das optoelektronische System kann aber auch andere Systeme, insbesondere System mit Pulsanwendungen (kurze Pulse mit hohen Leistungen), umfassen, für die eine hohe Ausgangsleistung, Monomodigkeit und/oder ein enges Abstrahlprofil des Laserstrahls wünschenswert sind. Beispielsweise kann eine Leistung des Lasers zwischen 10W und 1000W liegen. Beispielsweise kann der Laser mit Strömen zwischen 10A und 1000A elektrisch versorgt werden. Die großen Leistungen und Ströme, sowie das enge Abstrahlprofil können insbesondere durch beliebig großen Flächen (in der Aufsicht) erzielt werden. Durch die Oberflächenemission kann im Vergleich zu kantenemittierenden Lasern außerdem eine Integration des PCSELs in das optoelektronische System effizienter gestaltet werden.

Gemäß zumindest einer Ausführungsform ist ein Verfahren zur Herstellung eines oberflächenemittierenden Photonischer-Kristall-Lasers angegeben. Alle für den Laser offenbarten Merkmale werden auch für Herstellungsverfahren offenbart und umgekehrt.

Das Verfahren weist ein Formen einer zweiten Wellenleiterschicht auf. Beispielsweise wird die zweite Wellenleiterschicht durch epitaktisches Aufwachsen auf einem Halbleitersubstrat geformt. Das Halbleitersubstrat kann eines der oben genannten Materialsysteme aufweisen. Alternativ kann die zweite Wellenleiterschicht durch epitaktisches Aufwachsen auf einer zweiten Mantelschicht geformt werden, wobei die zweite Mantelschicht in einem diesem Schritt vorhergehenden Schritt auf dem Halbleitersubstrat aufgewachsen wurde.

Gemäß zumindest einer Ausführungsform umfasst das Verfahren weiterhin ein Aufbringen einer aktiven Schicht auf der zweiten Wellenleiterschicht, wobei die aktive Schicht zur Generierung elektromagnetischer Strahlung durch Ladungsträger Rekombination ausgebildet ist. Die aktive Schicht kann eine Mehrzahl von Halbleiterschichten umfassen, insbesondere einen Schichtstapel aus Materialen unterschiedlicher Bandlücken, um zumindest einen Quantentopf zu bilden. Die aktive Schicht kann durch epitaktisches Wachstum auf der zweiten Wellenleiterschicht geformt werden.

Gemäß zumindest einer Ausführungsform umfasst das Verfahren weiterhin ein Aufbringen einer ersten Wellenleiterschicht auf der aktiven Schicht. Die erste Wellenleiterschicht kann durch epitaktisches Wachstum auf der aktiven Schicht geformt werden. Die erste Wellenleiterschicht und die zweite Wellenleiterschicht bilden zusammen einen Wellenleiter zur Führung optischer Moden.

Gemäß zumindest einer Ausführungsform umfasst das Verfahren weiterhin ein Aufbringen einer ersten Mantelschicht auf der ersten Wellenleiterschicht. Die erste Mantelschicht kann durch epitaktisches Wachstum auf der ersten Wellenleiterschicht geformt werden. Die erste Mantelschicht und die zweite Mantelschicht (falls vorhanden) weisen einen niedrigeren Brechungsindex als die Wellenleiterschichten auf. Eine lateral laufende optische Welle wird somit durch Reflexion an der Grenzfläche im Wellenleiter gehalten.

Gemäß zumindest einer Ausführungsform umfasst das Verfahren weiterhin ein Aufbringen einer Kontaktschicht durch epitaktisches Wachstum auf der ersten Mantelschicht. Die Kontaktschicht kann Teil eines späteren elektrischen Kontaktelements sein. Die Kontaktschicht kann ein hochdotiertes Halbleitermaterial umfassen. Beispielsweise ist die Kontaktschicht n-dotiert. Gemäß zumindest einer Ausführungsform wird die Kontaktschicht in einem weiteren Prozessschritt strukturiert. Dass kann bedeuten, dass zumindest Teile der Kontaktschicht entfernt werden, um die darunterliegende erste Mantelschicht freizulegen. Durch die Kontaktschicht können pn-Übergänge in der Mantelschicht, und somit Verluste vermieden werden.

Gemäß zumindest einer Ausführungsform umfasst das Verfahren ferner ein Ausbilden zumindest eines p-Anschlussbereichs der ersten Mantelschicht zur Injektion von elektrisch positiven Ladungsträgern in die aktive Schicht. Beispielsweise wird der zumindest eine p-Anschlussbereich mittels Ionenimplantation in die freiliegenden Bereiche der ersten Mantelschicht geformt, wobei ein Lithografie-Schritt zum Einsatz kommen kann.

Gemäß zumindest einer Ausführungsform umfasst das Verfahren ferner ein Ausbilden zumindest eines n-Anschlussbereichs der ersten Mantelschicht zur Injektion von elektrisch negativen Ladungsträgern in die aktive Schicht. Möglicherweise wird der zumindest eine n-Anschlussbereich durch den von der Kontaktschicht bedeckten Bereich gebildet. Der n-Anschlussbereich kann undotiert sein. Das kann bedeuten, dass die erste Mantelschicht bei ihrer Abscheidung undotiert war, wobei der p-Anschlussbereich durch die oben erwähnte Ionenimplantation p-Typ leitfähig gemacht wurde, und der n-Anschlussbereich undotiert geblieben ist. Der n-Anschlussbereich kann durch den Bereich der ersten Mantelschicht definiert sein/werden, der nicht als p-Anschlussbereich ausgebildet ist, also zum Beispiel mittels Ionenimplantation im vorherigen Schritt dotiert wurde. Alternativ wird der zumindest eine n-Anschlussbereich ebenfalls mittels Ionenimplantation geformt, wobei ein Lithografie-Schritt zum Einsatz kommen kann. In diesem Fall kann der n-Anschlussbereich dotiert sein, insbesondere mit einem Dotierstoff des n-Typs, um eine erhöhte n-Typ Leitfähigkeit zu erhalten. Durch die p- und n-Anschlussbereiche können Ladungsträger von nur einer Seite zur aktiven Schicht diffundieren. Abschattungseffekte und/oder Absorptionseffekte können damit vermieden werden.

Gemäß zumindest einer Ausführungsform umfasst das Verfahren ferner ein Ausbilden von zueinander periodisch angeordneten Bereichen und weiteren Bereichen der zweiten Wellenleiterschicht, wobei sich ein Brechungsindex der Bereiche von einem Brechungsindex der weiteren Bereiche unterscheidet, und wobei die Bereiche und die weiteren Bereiche einen photonischen Kristall bilden. Durch den photonischen Kristall kann eine stehende optische Welle ausgebildet werden und Strahlung senkrecht zur Haupterstreckungsebene der aktiven Schicht ausgekoppelt werden. Auch andere Winkel als 90° sind denkbar.

Gemäß zumindest einer Ausführungsform umfasst das Ausbilden von zueinander periodisch angeordneten Bereichen und weiteren Bereichen der zweiten Wellenleiterschicht ein Ausbilden von Gräben oder Löchern in die zweite Wellenleiterschicht. Die Gräben/Löcher erstrecken sich von einer der aktiven Schicht abgewandten Oberfläche der zweiten Wellenleiterschicht bis in die zweite Wellenleiterschicht hinein. Alternativ, falls eine zweite Mantelschicht vorhanden ist, können sich die Gräben/Löcher von einer der aktiven Schicht abgewandten Oberfläche der zweiten Mantelschicht bis in die zweite Wellenleiterschicht hinein erstrecken. Die Bereiche der zweiten Wellenleiterschicht sind durch ein Material der zweiten Wellenleiterschicht definiert, insbesondere durch das verwendete Halbleitermaterial. Die weiteren Bereiche sind durch von den Gräben oder Löchern gebildeten Ausnehmungen definiert. Das bedeutet, dass die weiteren Bereiche durch Luft oder ein Gas gebildet werden. Gemäß zumindest einer Ausführungsform können die Ausnehmungen mit einem weiteren Material gefüllt werden, z.B. mittels Atomlagenabscheidung. In diesem Fall werden die weiteren Bereiche durch das weitere Material, z.B. ein Oxid, gebildet. Die Gräben oder Löcher können mittels Elektronenstrahl-Lithografie, Nanopräge-Lithografie, UV/DUV/EUV-Lithografie und/oder Ätzung geformt werden. Ein Durchmesser der Gräben/Löcher kann somit zwischen 5nm und 100nm, oder zwischen 10nm und 50nm liegen. Durch das Einbringen von Gräben kann der photonische Kristall effizient geformt werden. Weiterhin ist ein Überwachsen der photonischen Kristallstruktur nicht nötig.

In einer alternativen Ausführungsform können die Bereiche oder die weiteren Bereiche der ersten Wellenleiterschicht auch durch Strukturierung während des Wachstums und nachfolgendem Überwachsen gebildet werden. Beispielsweise wird die zweite Wellenleiterschicht durch Elektronenstrahllithographie und induktiv gekoppeltes Plasma strukturiert und anschließend epitaktisch überwachsen, um eine Vielzahl von Hohlräumen in die Schicht einzubetten. Die weiteren Bereiche der zweiten Wellenleiterschicht können beispielsweise durch die Hohlräume definiert sein, während die Bereiche durch das Halbleitermaterial der zweiten Wellenleiterschicht definiert sein können, oder umgekehrt. In dieser Ausführungsform, können die weiteren Bereiche also in der zweiten Wellenleiterschicht eingebettet, d.h. von dieser vollständig umgeben sein. Insbesondere erstrecken sich hier die weiteren Bereiche nicht bis an die Oberfläche der zweiten Wellenleiterschicht. Die Hohlräume können auch durch ein weiteres Material gefüllt sein. Durch das beschriebene Herstellungsverfahren kann eine defektfreie oder wenigstens defektarme Wellenleiterschicht geformt werden.

Gemäß zumindest einer Ausführungsform weist das Verfahren weiterhin ein Aufbringen eines ersten elektrischen Kontaktelements auf jedem der p-Anschlussbereiche und/oder ein Aufbringen eines zweiten elektrischen Kontaktelements auf jedem der n-Anschlussbereiche auf. Die ersten und zweiten elektrischen Kontaktelemente können bevorzugt ein Metall umfassen oder daraus bestehen. Die ersten und zweiten elektrischen Kontaktelemente können beispielsweise mittels Sputterverfahren oder einem anderen Abscheideverfahren aufgebracht werden. Es ist auch möglich, dass die oben beschriebene strukturierte Kontaktschicht Teil der ersten oder der zweiten elektrischen Kontaktelemente ist. Die elektrischen Kontaktelemente verbinden die Anschlussbereiche der Mantelschicht mit einer Quelle für elektrische Ladungsträger. Außerdem können die elektrischen Kontaktelemente als reflektierende Schicht ausgebildet sein, um vom photonischen Kristall gestreute elektromagnetische Strahlung zu reflektieren.

Weitere Ausführungsformen des Herstellungsverfahrens ergeben sich für den geübten Leser aus den oben beschriebenen Ausführungsformen für den PCSEL. Die vorherige und nachfolgende Beschreibung bezieht sich gleichermaßen auf den Laser, das optoelektronische System und die Herstellung des Lasers.

Weitere Vorteile, vorteilhafte Ausführungsformen und Weiterbildungen ergeben sich aus den im Folgenden in Verbindung mit den Figuren beschriebenen Ausführungsbeispielen.

In den Ausführungsbeispielen und Figuren können gleiche, gleichartige oder gleich wirkende Elemente jeweils mit denselben Bezugszeichen versehen sein. Die dargestellten Elemente und deren Größenverhältnisse untereinander sind nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben groß dargestellt sein.

Figuren 1 bis 4 zeigen einen oberflächenemittierenden Photonischer-Kristall-Laser im Querschnitt gemäß Ausführungsbeispielen.

Figuren 5 bis 7 zeigen einen oberflächenemittierenden Photonischer-Kristall-Laser in Aufsicht gemäß Ausführungsbeispielen.

Figur 8 zeigt eine schematische Darstellung eines optoelektronischen Systems gemäß einem Ausführungsbeispiel.

Figuren 9 bis 13 zeigen Zwischenprodukte bei der Herstellung eines PCSELs gemäß einem Ausführungsbeispiel.

Figur 14 zeigt ein Endprodukt bei der Herstellung eines PCSELs gemäß einem Ausführungsbeispiel.

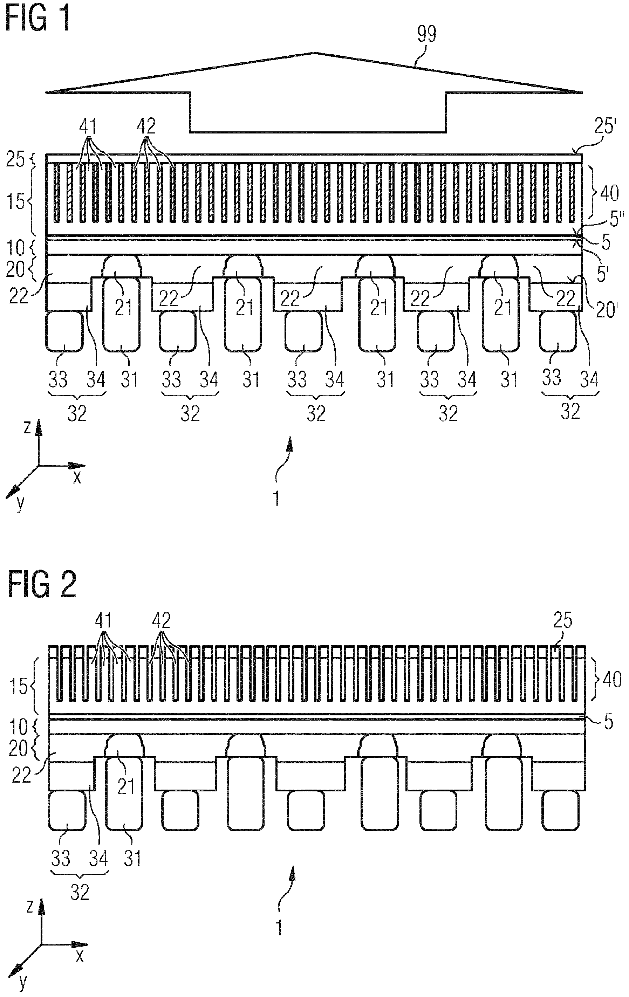

In Verbindung mit der Figur 1 ist ein oberflächenemittierender Photonischer-Kristall-Laser 1, PCSEL, gezeigt. Der PCSEL 1 weist eine aktive Schicht 5 auf, die dazu ausgebildet ist, elektromagnetische Strahlung 99 (veranschaulicht durch einen Pfeil, nach Interaktion mit einem photonischen Kristall) durch Ladungsträgerrekombination zu generieren. Die aktive Schicht kann ein Halbleitermaterial aufweisen. Die aktive Schicht 5 weist eine erste Hauptfläche 5' und eine der ersten Hauptfläche 5' gegenüberliegende zweite Hauptfläche 5" auf. Die aktive Schicht weist eine Haupterstreckungsebene auf, die in lateralen Richtungen x, y verläuft. In einer transversalen Richtung z, die senkrecht auf der Haupterstreckungsebene steht, weist die aktive Schicht eine Dicke auf. Die ersten Hauptfläche 5' und zweite Hauptfläche 5" verlaufen parallel zu den lateralen Richtungen x, y. Die aktive Schicht 5 kann durch eine Mehrzahl von Schichten (nicht gezeigt) gebildet sein. Insbesondere kann die aktive Schicht 5 zumindest einen Quantentopf bilden, der dazu vorgesehen und ausgebildet ist, unter Anlegen eines Treiberstroms elektromagnetische Strahlung 99 einer vorbestimmten Wellenlänge zu emittieren. Beispielsweise ist der zumindest eine Quantentopf ein 2D-Quantentopf, der durch eine dünne Zwischenschicht eines ersten Materials umgeben von Barriereschichten eines zweiten Materials gebildet wird. Die Barriere-Schichten weisen eine größere Bandlücke als die Zwischenschicht auf.

Der PCSEL 1 weist weiterhin eine auf der ersten Hauptfläche 5' angeordnete erste Wellenleiterschicht 10 und eine auf der zweiten Hauptfläche 5" angeordnete zweite Wellenleiterschicht 15 auf. Mit anderen Worten ist die aktive Schicht 5 zwischen der ersten Wellenleiterschicht 10 und der zweiten Wellenleiterschicht 15 angeordnet und bildet mit diesen eine jeweilige Grenzfläche. Die Wellenleiterschichten 10, 15 können ein Halbleitermaterial aufweisen. In dem Ausführungsbeispiel nach Fig. 1 ist eine Dicke der ersten Wellenleiterschicht 10 geringer als eine Dicke der zweiten Wellenleiterschicht 15. Die Dicken der Wellenleiterschichten 10, 15 bezieht sich hierbei auf eine Ausdehnung der Wellenleiterschichten 10, 15 in transversaler Richtung z. Die erste Wellenleiterschicht 10 bildet zusammen mit der zweiten Wellenleiterschicht 15 einen Wellenleiter, in dem die aktive Schicht 5 eingebettet ist. Durch die unterschiedlichen Dicken der Wellenleiterschichten 10, 15 ergibt sich in dem gezeigten Ausführungsbeispiel ein asymmetrisches Wellenleiterprofil. Die erste Wellenleiterschicht 10 und die zweite Wellenleiterschicht 15 können dotiert, undotiert oder intrinsisch dotiert sein. Die zweite Wellenleiterschicht 15 ist aber bevorzugt undotiert oder intrinsisch dotiert.

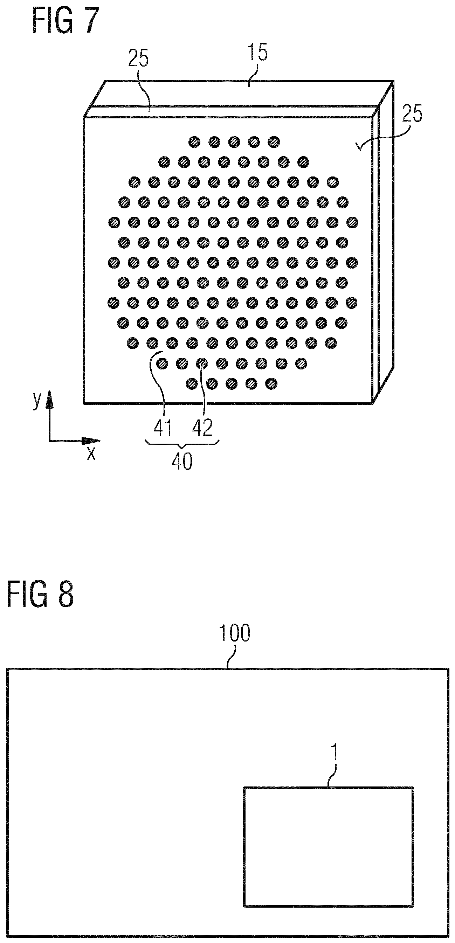

Die zweite Wellenleiterschicht 15 weist zueinander periodisch angeordnete Bereiche 41 und weitere Bereiche 42 auf. Ein Brechungsindex der Bereiche 41 unterscheidet sich von einem Brechungsindex der weiteren Bereiche 42. Auf diese Weise bilden die Bereiche 41 und die weiteren Bereiche 42 einen photonischen Kristall 40. Die elektromagnetische Strahlung 99 wird durch Interaktion mit dem photonischen Kristall 40 in transversaler Richtung z abgestrahlt. Die Bereiche 41 und die weiteren Bereiche 42 können unterschiedliche Materialien aufweisen. Beispielsweise weisen die Bereiche 41 ein Halbleitermaterial auf, während die weiteren Bereiche ein anderes Halbleitermaterial, Luft, Gas, oder ein Oxid aufweisen. Ein Brechungsindexunterschied zwischen den Bereichen 41 und den weiteren Bereichen 42 kann groß sein. Die weiteren Bereiche 42 können nachträglich in die Wellenleiterschicht 15 eingebracht worden sein. Das kann bedeuten, dass die Wellenleiterschicht 15 zunächst als kontinuierliche Schicht, das Material der Bereiche 41 aufweisend, geformt wird. Die weiteren Bereiche 42 können durch Materialveränderung, Materialentfernung oder Materialersetzung geformt sein. Die weiteren Bereiche 42 können matrixförmig angeordnet sein oder sich - in einer Aufsicht (siehe Fig. 7) - auf Schnittpunkten eines Gitters befinden. Das Gitter kann aus einer Basis mit mehreren Elementen bestehen. Eine Gitterperiode kann so gewählt werden, dass sie mit einer Wellenlänge der von der aktiven Schicht 5 generierten Strahlung 99 im Wesentlichen übereinstimmt, oder ein ganzzahliges oder nicht-ganzzahliges Vielfaches davon darstellt. In dem in Fig. 1 gezeigten Ausführungsbeispiel erstecken sich die weiteren Bereiche 42 von einer der aktiven Schicht 5 abgewandten Oberfläche der zweiten Wellenleiterschicht 15 bis in die zweite Wellenleiterschicht 15 hinein. In transversaler Richtung z sind die weiteren Bereiche 42 von der aktiven Schicht 5 beabstandet. Es ist auch möglich (aber nicht gezeigt), dass die weiteren Bereiche 42 in der zweiten Wellenleiterschicht 15 eingebettet sind, das heißt, sich nicht bis zur Oberfläche der zweiten Wellenleiterschicht 15 erstrecken. Eine solche Anordnung kann beispielsweise mittels Regrowth-Verfahren hergestellt werden. In diesem Fall können die weiteren Bereiche 42 beispielsweise durch Hohlräume bzw. abgeschlossene Zonen in der zweiten Wellenleiterschicht 15 gebildet sein.

Der PCSEL 1 weist weiterhin eine auf der ersten Wellenleiterschicht 10 angeordnete erste Mantelschicht 20 auf. Die erste Mantelschicht 20 bildet eine Grenzfläche mit der ersten Wellenleiterschicht 10. Das bedeutet, dass die erste Wellenleiterschicht 10 zwischen der ersten Mantelschicht 20 und der aktiven Schicht 5 angeordnet ist. Die erste Mantelschicht 20 weist beispielsweise ein Halbleitermaterial auf. Die erste Mantelschicht ist bevorzugt zumindest in Bereichen dotiert. Die erste Mantelschicht 20 weist zumindest einen p-Anschlussbereich 21 zur Injektion von elektrisch positiven Ladungsträgern in die aktive Schicht 5 auf. Der p-Anschlussbereich kann zum Beispiel durch Dotierung eines Bereichs der ersten Mantelschicht 20 mit einem Dotierstoff des p-Typs geformt sein. Die erste Mantelschicht 20 weist ferner zumindest einen n-Anschlussbereich 22 zur Injektion von elektrisch negativen Ladungsträgern in die aktive Schicht 5 auf. Der n-Anschlussbereich kann zum Beispiel durch Dotierung eines weiteren Bereichs der ersten Mantelschicht 20 mit einem Dotierstoff des n-Typs geformt sein. Das gezeigte Beispiel zeigt eine Mehrzahl von p- und n-Anschlussbereichen, die unabhängig und einzeln voneinander über Kontaktelemente 31, 32 elektrisch angesteuert werden können. Die erste Mantelschicht 20 bildet eine Oberfläche 20'. Die Oberfläche 20' liegt der ersten Wellenleiterschicht 10 gegenüber, d.h. ist dieser abgewandt. Die Oberfläche 20' kann auch als Anschlussseite 20' bezeichnet werden.

Der PCSEL 1 nach Figur 1 weist weiterhin eine zweite Mantelschicht 25 auf, die auf der zweiten Wellenleiterschicht 15 angeordnet ist. Die zweite Mantelschicht 25 bildet eine Grenzfläche mit der zweiten Wellenleiterschicht 15. Mit anderen Worten ist die zweite Wellenleiterschicht 15 zwischen der zweiten Mantelschicht 25 und der aktiven Schicht 5 angeordnet. Die zweite Mantelschicht 25 ist optional. Die zweite Mantelschicht 25 kann ein Halbleitermaterial aufweisen. Die zweite Mantelschicht 25 kann bevorzugt undotiert sein. Die zweite Mantelschicht 25 kann, in transversaler Richtung z, dünner als die erste Mantelschicht 20 sein. Die zweite Mantelschicht 25 bildet eine Oberfläche 25'. Die Oberfläche 25' liegt der zweiten Wellenleiterschicht 15 gegenüber, d.h. ist dieser abgewandt. Die Oberfläche 25' kann auch als Abstrahlseite 25' bezeichnet werden. Das kann bedeuten, dass die von der aktiven Schicht 5 generierte elektromagnetische Strahlung 99 nach Manipulation durch den photonischen Kristall 40 über die Abstrahlseite 25' vom PCSEL 1 abgestrahlt wird.

Der PCSEL 1 nach Figur 1 weist weiterhin eine Kontaktschicht 34 auf. Die Kontaktschicht 34 ist auf der ersten Mantelschicht 20, d.h. auf der Kontaktseite 20', zumindest in Bereichen angeordnet. Die Kontaktschicht 34 kann eine hochdotierte Halbleiterschicht sein. Die Kontaktschicht 34 kann Teil eines ersten oder eines zweiten Kontaktelements 31, 32 sein, über das der zumindest eine n- oder p-Anschlussbereich 21, 22, elektrisch kontaktiert wird. Im gezeigten Beispiel ist die Kontaktschicht 34 Teil des zweiten Kontaktelements 32, über das der n-Anschlussbereich 22 elektrisch kontaktiert wird. Die Kontaktschicht 34 ist strukturiert, so dass nur n-Anschlussbereiche 22 der ersten Mantelschicht 20 von ihr bedeckt sind und die übrigen Bereiche der ersten Mantelschicht 20, die den p-Anschlussbereichen 22 entsprechen, offenliegen. Der PCSEL 1 nach Figur 1 weist weiterhin eine weitere Kontaktschicht 33 auf, die auf der Kontaktschicht 34 angeordnet ist. Die weitere Kontaktschicht 33 kann beispielsweise ein Metall aufweisen. Die weitere Kontaktschicht 33 ist strukturiert und bedeckt Bereiche der Kontaktschicht 34. Die Kontaktschicht 34 und die weitere Kontaktschicht 33 bilden zusammen das zweite Kontaktelement 32. Der PCSEL 1 weist eine Mehrzahl von zweiten Kontaktelementen 32 auf, entsprechend der Anzahl der n-Anschlussbereiche 22. Der PCSEL 1 weist weiterhin ein erstes Kontaktelement 31 auf, das auf dem p-Anschlussbereich angeordnet ist. Das erste Kontaktelement 31 kann beispielsweise ein Metall aufweisen. Das erste Kontaktelement 31 ist strukturiert und bedeckt die p-Anschlussbereiche 21. Der PCSEL 1 weist eine Mehrzahl von ersten Kontaktelementen 31 auf, entsprechend der Anzahl der p-Anschlussbereiche 21.

In Verbindung mit der Figur 2 ist ein weiteres Ausführungsbeispiel des PCSELs 1 gezeigt. Das Ausführungsbeispiel nach Figur 2 unterscheidet sich von Ausführungsbeispiel nach Figur 1 darin, dass die weiteren Bereiche 42 der zweiten Wellenleiterschicht 15 durch Ausnehmungen der zweiten Wellenleiterschicht 15 gebildet sind. Hierbei werden die Ausnehmungen der zweiten Wellenleiterschicht 15 durch Gräben oder Löcher geformt, die sich von der Oberfläche 25' der zweiten Mantelschicht 25 bis in die zweite Wellenleiterschicht 15 hinein erstrecken. Die zweite Mantelschicht 25 ist wiederum optional. Ein Durchmesser der Gräben kann im Nanometer-Bereich liegen. Die Form der Gräben kann zylindrisch sein, d.h. in der Aufsicht können die Gräben ein kreisförmiges oder elliptisches Profil haben (siehe Fig. 7). Es ist aber auch möglich, dass die Gräben ein anderes Profil, z.B. polygonales, insbesondere drei- oder viereckiges, Profil aufweisen. In der transversalen Richtung z können die Gräben nah an die aktive Schicht 5 heranreichen. Ein Grabenfuß der Gräben bleibt aber von der aktiven Schicht 5 beabstandet.

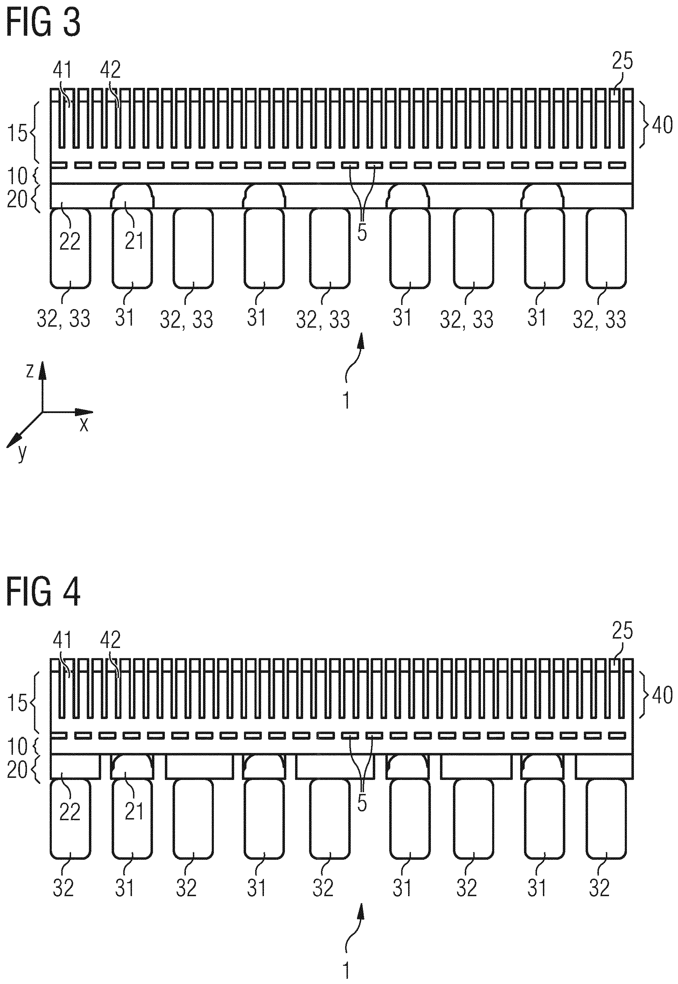

In Verbindung mit der Figur 3 ist ein weiteres Ausführungsbeispiel des PCSELs 1 gezeigt. Das Ausführungsbeispiel nach Figur 3 unterscheidet sich von Ausführungsbeispiel nach Figur 2 unter anderem darin, dass die aktive Schicht 5 eine Mehrzahl von 0-dimensionalen Quantenpunkten (in allen drei Raumrichtungen begrenzte Strukturen) oder 1-dimensionalen Quantendrähten (in diesem Fall erstrecken sich die Strukturen nur in die laterale y-Richtung, aus der Bildebene hinaus) verwendet. Die Dichte der Quantenpunkte oder Quantendrähte kann beispielsweise entlang lateraler Richtungen x, y variieren. In Bereichen höherer Dichte wird dann mehr Strahlung erzeugt als im Bereich niedriger Dichte. So kann die Position der strahlungsemittierenden Bereiche der aktiven Schicht 5 weiter eingestellt werden. Des Weiteren weist der PCSEL 1 gemäß Figur 3 keine Kontaktschicht 34 auf. Die ersten Kontaktelemente 31 sind in direktem Kontakt mit den p-Anschlussbereichen 21. Die zweiten Kontaktelemente 32, bestehend aus der weiteren Kontaktschicht 33, sind in direktem Kontakt mit den n-Anschlussbereichen 22. Die erste Mantelschicht 20 wird durch eine durchgehende Schicht gebildet, in der sich die p-Anschlussbereiche 21 und die n-Anschlussbereiche 22 lateral abwechseln.

In Verbindung mit der Figur 4 ist ein weiteres Ausführungsbeispiel des PCSELs 1 gezeigt. Das Ausführungsbeispiel nach Figur 4 unterscheidet sich von Ausführungsbeispiel nach Figur 3 darin, dass die p-Anschlussbereiche 21 und die n-Anschlussbereiche 22 nicht mehr Teil einer einfach zusammenhängenden ersten Mantelschicht 20 sind. Vielmehr handelt es sich bei den p-Anschlussbereichen 21 und den n-Anschlussbereichen 22 um voneinander getrennte und beabstandete Elemente. Beispielsweise wurde dazu die in den vorhergehenden Figuren gezeigte erste Mantelschicht 20 strukturiert. Durch die Ausgestaltung der Anschlussbereiche 21, 22 als voneinander beabstandete und getrennte Elemente kann eine Rekombination von Ladungsträgern außerhalb der aktiven Schicht 5 unterdrückt, und pn-Übergänge in der ersten Mantelschicht 20 vermieden werden.

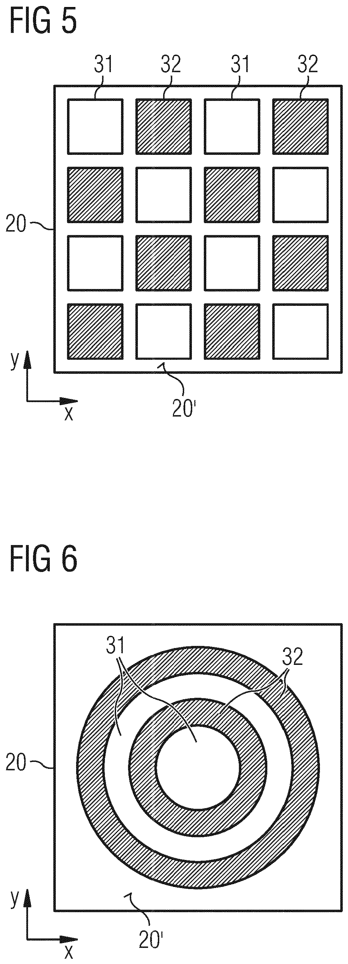

In Verbindung mit der Figur 5 ist ein weiteres Ausführungsbeispiel des PCSELs 1 in einer Aufsicht gezeigt. Die Aufsicht bezieht sich hierbei auf eine Sicht auf die Anschlussseite 20' der ersten Mantelschicht 20. Wie in Figur 5 zu sehen sind die ersten Kontaktelemente 31 und die zweiten Kontaktelemente 32 schachbrettartig angeordnet. Das heißt, dass zwischen je zwei ersten Kontaktelementen 31 in lateralen Richtungen x, y ein zweites Kontaktelement 32 angeordnet ist, und umgekehrt. Der PCSEL 1 umfasst in diesem Beispiel je 8 erste und zweite Kontaktelemente 31, 32, die in einem 4x4 Array angeordnet sind. Diese Zahlen sind als willkürliche Beispiele zu verstehen, und der PCSEL 1 kann auf größere bzw. kleinere Flächen mit mehr oder weniger als insgesamt 16 Anschlusselemente 31, 32 ausgedehnt bzw. verkleinert werden. Außerdem lassen sich die lateralen Durchmesser der Kontaktelemente 31, 32 in Bezug auf die Fläche der Anschlussseite 20' beliebig anpassen. Die Anzahl der ersten Kontaktelemente 31 (und damit die Anzahl der p-Anschlussbereiche 21) kann sich von der Anzahl der zweiten Kontaktelemente 32 (und damit die Anzahl der n-Anschlussbereiche 22) unterscheiden.

In Verbindung mit der Figur 6 ist ein alternatives Ausführungsbeispiel eines PCSELs 1 in einer Aufsicht auf die Anschlussseite 20' gezeigt. In diesem Fall sind die ersten und zweiten Kontaktelemente 31, 32 als konzentrische Ringe bzw. Kreise mit unterschiedlichen Durchmessern ausgebildet. Ein zweites ringförmig ausgebildetes elektrisches Kontaktelement 32 umschließt ein erstes innerstes erstes Kontaktelement 31 in lateralen Richtungen x, y. Ein weiteres ringförmig ausgebildetes erstes Kontaktelement 31 umschließt das zweite elektrische Kontaktelement 32, und ein weiteres ringförmig ausgebildetes zweites Kontaktelement 32 umschließt das weitere erste Kontaktelement 31. Dieses Schema kann beliebig erweitert werden und/oder mit einem zweiten Kontaktelement 32 als innerstes Kontaktelement starten.

In Verbindung mit der Figur 7 ist ein Ausführungsbeispiel des PCSELs 1 in einer Aufsicht auf die Abstrahlseite 25' gezeigt. Es sind nur die zweite Mantelschicht 25 und die darunterliegende zweite Wellenleiterschicht 15 gezeigt, weitere Schichten sind aus Gründen der Übersichtlichkeit nicht gezeigt. Wie zu sehen, sind die weiteren Bereichen 42 als Gräben ausgebildet, die sich von der Abstrahlseite 25' bis in die zweite Wellenleiterschicht 15 hinein erstrecken. Die sich zwischen den Gräben befindenden Gebiete der zweiten Wellenleiterschicht 15 bilden die Bereiche 41 der zweiten Wellenleiterschicht 15. Die Gräben sind beispielhaft in einem hexagonalen Raster angeordnet. Die Bereiche 41 und die weiteren Bereiche 42 bilden den photonischen Kristall 40.

Wie in Figur 8 angedeutet kann der PCSEL 1 in einem optoelektronischen System 100 integriert sein. Beispielsweise handelt es sich bei dem optoelektronischen System 100 um ein LIDAR-System. Das optoelektronische System 100 kann auch andere Systeme umfassen, in denen üblicherweise VCSELs (engl.: "vertical cavity surface emitting laser") oder EELs (engl.: "edge emitting laser") zum Einsatz kommen. Die elektrischen Kontaktelemente 31, 32 des PCSELs 1 können mittels Drahtverbindungen oder Flip-Chip-Montage mit einer Leiterplatte oder Platine, oder einem anderen Halbleierbaustein (z.B. einem Treiber-IC) des optoelektronischen Systems 100 verbunden werden. Das optoelektronische System 100 kann weitere optische und/oder elektronische Komponenten aufweisen, wie beispielsweise optische Filter, Linsen, Photodetektoren und/oder integrierte Schaltkreise.

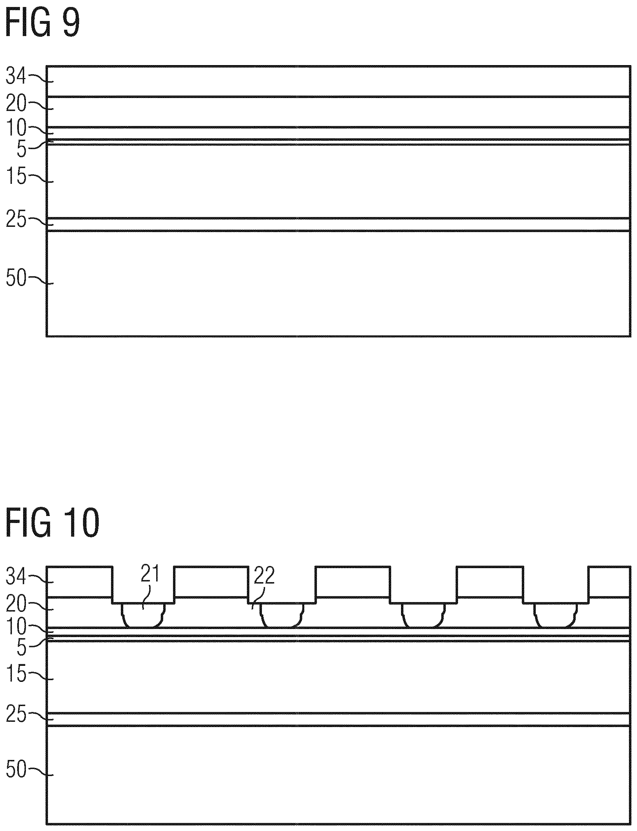

In den Figuren 9-14 ist ein mögliches Herstellungsverfahren für einen PCSEL 1 gezeigt. Figur 9 zeigt einen Schichtstapel, der durch epitaktisches Wachstum gebildet werden kann. Der Schichtstapel umfasst ein Substrat 50, welches ein Halbleitersubstrat sein kann. Auf dem Substrat 50 wird die zweite Mantelschicht 25 geformt. Die zweite Mantelschicht 25 ist allerdings optional, wie oben ausgeführt. Als erste Schichten auf dem Substrat 50 können z.B. auch eine Bufferschicht zur Verbesserung des Wachstums und/oder eine Löseschicht (engl.: "release layer"), die ein späteres Ablösen des Substrates 50 oder der Bufferschicht erleichtert, abgeschieden werden.

Auf der zweiten Mantelschicht 25 wird die zweite Wellenleiterschicht 15 geformt. Die zweite Wellenleiterschicht 15 kann auch direkt auf dem Substrat 50 (oder der Bufferschicht oder der Löseschicht) geformt werden. Auf der zweiten Wellenleiterschicht 15 wird die aktive Schicht 5 aufgebracht, die zur Generierung elektromagnetischer Strahlung 99 durch Ladungsträgerrekombination ausgebildet ist. Auf der aktiven Schicht 5 wird die erste Wellenleiterschicht 10 aufgebracht. Auf der ersten Wellenleiterschicht 10 wird die erste Mantelschicht 20 aufgebracht. Im gezeigten Beispiel wird auf die erste Mantelschicht 20 die Kontaktschicht 34 aufgebracht, die insbesondere eine hochdotierte Halbleiterschicht des n-Typs sein kann. Die Kontaktschicht 34 ist optional.

Figur 10 zeigt das Zwischenprodukt gemäß Figur 9 nach weiteren Prozessschritten. Gemäß Figur 10 wird die Kontaktschicht 34 strukturiert, so dass Bereiche der darunterliegenden ersten Mantelschicht 20 freigelegt werden. Des Weiteren werden p-Anschlussbereiche 21 der ersten Mantelschicht 20 zur Injektion von elektrisch positiven Ladungsträgern in die aktive Schicht ausgebildet. Die p-Anschlussbereiche 21 können beispielsweise mittels Ionenimplantation geformt werden. Alternativ können Anschlussbereiche für unterschiedliche Ladungsträger auch durch mehrfaches Wachstum erzeugt werden. Die Details eines solchen Prozessablaufs sind für den Fachmann/ die Fachfrau ableitbar. Des Weiteren werden n-Anschlussbereiche 22 der ersten Mantelschicht 20 zur Injektion von elektrisch negativen Ladungsträgern in die aktive Schicht 5 ausgebildet. Die n-Anschlussbereiche 22 können beispielsweise durch die Bereiche der ersten Mantelschicht 20 definiert werden, die nicht als p-Anschlussbereiche 21 ausgebildet sind. Die n-Anschlussbereiche 22 sind im gezeigten Beispiel von der Kontaktschicht 34 bedeckt.

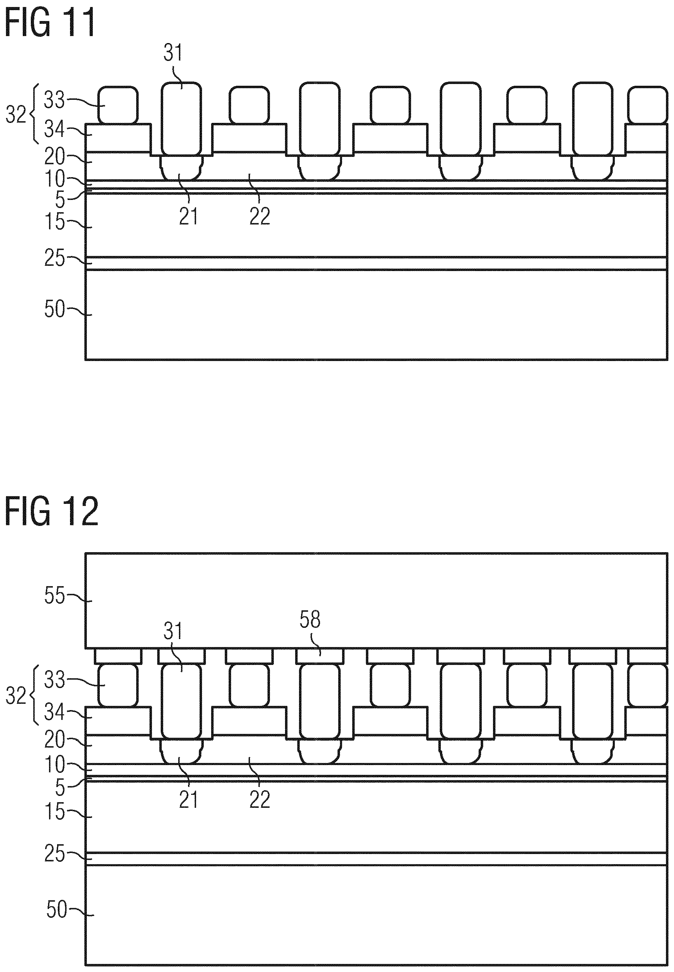

Figur 11 zeigt das Zwischenprodukt gemäß Figur 10 nach weiteren Prozessschritten. Gemäß Figur 11 wird auf die Kontaktschicht 34, bzw. auf deren Bereiche, die weitere Kontaktschicht 33 aufgebracht. Die weitere Kontaktschicht 33 kann ein Metall aufweisen und mittels Sputterverfahren gebildet werden. Die Kontaktschicht 34 und die weitere Kontaktschicht 33 formen die zweiten elektrischen Kontaktelemente 32, die folglich auf jedem der n-Anschlussbereiche 22 angeordnet sind. Ferner werden erste Kontaktelement 31 auf jedem der p-Anschlussbereiche aufgebracht. Die ersten Kontaktelemente 31 können ebenfalls bevorzugt ein Metall aufweisen und mittels Sputterverfahren gebildet werden.

Figur 12 zeigt das Zwischenprodukt gemäß Figur 11 nach weiteren Prozessschritten. Gemäß Figur 12 werden die ersten und zweiten Kontaktelemente 31, 32 mit einem weiteren Substrat 55 verbunden. Dazu kann ein Bond-Verfahren verwendet werden. Das weitere Substrat 55 kann Bondpads 58 aufweisen, über die die jeweiligen Kontaktelemente 31, 32 mit dem weiteren Substrat 55 verbunden werden. Das weitere Substrat 55 kann ein Trägersubstrat sein, das nach dem Herstellungsverfahren wieder entfernt wird. Bevorzugt kann das weitere Substrat 55 aber eine anwenderspezifische integrierte Schaltung, kurz ASIC, umfassen. Die Schaltung kann eine Vielzahl von Schaltern umfassen, bei denen es sich um Transistoren, insbesondere Dünnfilmtransistoren, handeln kann. Jeder Schalter kann mit wenigstens einem der Kontaktelemente 31, 32 elektrisch verbunden werden. Auf diese Weise lassen sich die Kontaktelemente 31, 32, und somit die Anschlussbereiche 21, 22, separat ansteuern.

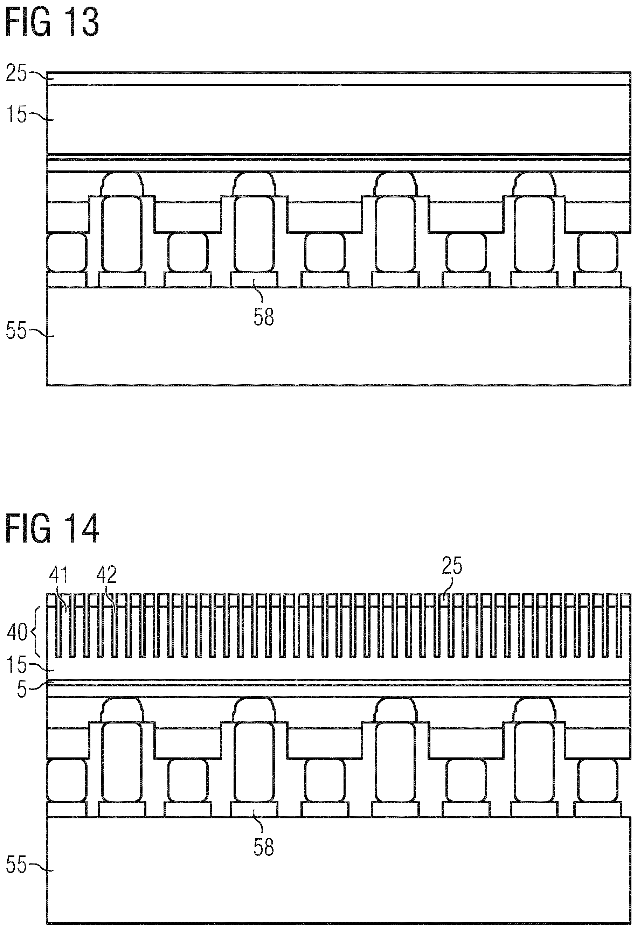

Figur 13 zeigt das Zwischenprodukt gemäß Figur 12 nach weiteren Prozessschritten. Gemäß Figur 13 wird das Zwischenprodukt um 180° gedreht, so dass das weitere Substrat 55 als Träger fungiert. Des Weiteren wird das Substrat 50 entfernt, beispielsweise mittels Schleif- und/oder Ätzverfahren. Dadurch wird die zweite Mantelschicht 25 freigelegt. Alternativ, falls keine zweite Mantelschicht 25 vorhanden ist, wird die zweite Wellenleiterschicht 15 freigelegt. In diesem Fall könnte, in einem optionalen Schritt, die zweite Mantelschicht 25 nun durch ein Abscheideverfahren geformt werden. Alternativ kann auch die zweite Wellenleiterschicht 15 durch ein Abscheideverfahren geformt werden.

Figur 14 zeigt das Endprodukt des Herstellungsprozesses gemäß Figuren 9 bis 13 nach weiteren Prozessschritten. Mittels eines Strukturierungsverfahrens (z.B. Elektronenstrahllithografie und Ätzen etc.) werden Gräben in die optionale zweite Mantelschicht 25 und die darunterliegende zweite Wellenleiterschicht 15 eingebracht. Dadurch werden zueinander periodisch angeordnete Bereiche 41 und weitere Bereichen 42 der zweiten Wellenleiterschicht 15 ausgebildet. Die Gräben bilden Ausnehmungen der zweiten Wellenleiterschicht 15, die mit Luft oder Gas gefüllt sein können. Hierdurch unterscheidet sich ein Brechungsindex der Bereiche 41 von einem Brechungsindex der weiteren Bereiche 42, wodurch ein photonischer Kristall 40 gebildet wird.

Die Erfindung ist nicht durch die Beschreibung anhand der Ausführungsbeispiele auf diese beschränkt. Die Erfindung wird lediglich definiert durch die in den unabhängigen Ansprüchen angegebenen technischen Merkmale.

Bezugszeichenliste

| | |
|---|---|
| 1 | PCSEL |
| 5 | aktive Schicht |
| 5' | erste Hauptfläche |
| 5" | zweite Hauptfläche |
| 10 | erste Wellenleiterschicht |
| 15 | zweite Wellenleiterschicht |
| 20 | erste Mantelschicht |
| 20' | Oberfläche der ersten Mantelschicht |
| 21 | p-Anschlussbereich |
| 22 | n-Anschlussbereich |
| 25 | zweite Mantelschicht |
| 25' | Oberfläche der zweiten Mantelschicht |
| 31 | erstes elektrisches Kontaktelement |
| 32 | zweites elektrisches Kontaktelement |
| 33 | weitere Kontaktschicht |
| 34 | Kontaktschicht |
| 40 | photonischer Kristall |
| 41 | Bereich |
| 42 | weiterer Bereich |
| 50 | Substrat |
| 55 | weiteres Substrat |
| 58 | Kontaktfläche |
| 99 | elektromagnetische Strahlung |
| 100 | optoelektronisches System |
| x,y | laterale Richtungen |
| z | transversale Richtung |

Patentansprüche

1. Oberflächenemittierender Photonischer-Kristall-Laser (1), aufweisend:

   - eine aktive Schicht (5) zur Generierung elektromagnetischer Strahlung (99) durch Ladungsträgerrekombination, wobei die aktive Schicht (5) eine erste Hauptfläche (5') und eine der ersten Hauptfläche (5') gegenüberliegende zweite Hauptfläche (5'') aufweist,
   - eine auf der ersten Hauptfläche (5') angeordnete erste Wellenleiterschicht (10),
   - eine auf der zweiten Hauptfläche (5") angeordnete zweite Wellenleiterschicht (15), die zueinander periodisch angeordnete Bereiche (41) und weitere Bereiche (42) aufweist, wobei sich ein Brechungsindex der Bereiche (41) von einem Brechungsindex der weiteren Bereiche (42) unterscheidet, und wobei die Bereiche (41) und die weiteren Bereiche (42) einen photonischen Kristall (40) bilden, und
   - eine auf der ersten Wellenleiterschicht (10) angeordnete erste Mantelschicht (20), die zumindest einen p-Anschlussbereich (21) zur Injektion von elektrisch positiven Ladungsträgern in die aktive Schicht (5) aufweist, **dadurch gekennzeichnet, dass**
   - die erste Mantelschicht (20) zumindest einen n-Anschlussbereich (22) zur Injektion von elektrisch negativen Ladungsträgern in die aktive Schicht (5) aufweist.

2. Oberflächenemittierender Photonischer-Kristall-Laser (1) nach Anspruch 1, wobei die zweite Wellenleiterschicht (15) ein Material aufweist, welches die Bereiche (41) der zweiten Wellenleiterschicht (15) definiert, und wobei die weiteren Bereiche (42) der zweiten Wellenleiterschicht (15) durch Ausnehmungen der zweiten Wellenleiterschicht (15) definiert sind.

3. Oberflächenemittierender Photonischer-Kristall-Laser nach Anspruch 2, wobei die Ausnehmungen der zweiten Wellenleiterschicht (15) durch Gräben oder Löcher in der zweiten Wellenleiterschicht (15) gebildet sind, die sich von einer der aktiven Schicht (5) abgewandten Oberfläche der zweiten Wellenleiterschicht (15) bis in die zweite Wellenleiterschicht (15) hinein erstrecken.

4. Oberflächenemittierender Photonischer-Kristall-Laser (1) nach einem der Ansprüche 1 bis 3, wobei die erste Wellenleiterschicht (10) undotiert oder intrinsisch dotiert ist.

5. Oberflächenemittierender Photonischer-Kristall-Laser (1) nach einem der Ansprüche 1 bis 4, wobei die zweite Wellenleiterschicht (15) undotiert oder intrinsisch dotiert ist.

6. Oberflächenemittierender Photonischer-Kristall-Laser (1) nach einem der Ansprüche 1 bis 5, wobei eine Dicke der ersten Wellenleiterschicht (10) geringer ist als eine Dicke der zweiten Wellenleiterschicht (15).

7. Oberflächenemittierender Photonischer-Kristall-Laser (1) nach einem der Ansprüche 1 bis 6, weiterhin aufweisend eine auf der zweiten Wellenleiterschicht (15) angeordnete zweite Mantelschicht (25).

8. Oberflächenemittierender Photonischer-Kristall-Laser (1) nach Anspruch 2 und 7, wobei die Ausnehmungen der zweiten Wellenleiterschicht (15) durch Gräben in der zweiten Wellenleiterschicht (15) gebildet sind, die sich von einer der zweiten Wellenleiterschicht abgewandten Oberfläche (25') der zweiten Mantelschicht (25) bis in die zweite Wellenleiterschicht (15) hinein erstrecken.

9. Oberflächenemittierender Photonischer-Kristall-Laser (1) nach einem der Ansprüche 7 bis 8, wobei die zweite Mantelschicht (25) undotiert oder intrinsisch dotiert ist.

10. Oberflächenemittierender Photonischer-Kristall-Laser (1) nach einem der Ansprüche 1 bis 9, wobei die aktive Schicht (5) zumindest einen Quantentopf bildet, der dazu vorgesehen und ausgebildet ist, unter Anlegen eines Treiberstroms elektromagnetische Strahlung (99) einer vorbestimmten Wellenlänge zu emittieren.

11. Oberflächenemittierender Photonischer-Kristall-Laser (1) nach einem der Ansprüche 1 bis 10, wobei eine Abstrahlrichtung (z) des Lasers (1) senkrecht auf einer Haupterstreckungsebene der zweiten Wellenleiterschicht (15) steht und elektromagnetische Strahlung (99) über eine der aktiven Schicht (5) abgewandten Oberfläche der zweiten Wellenleiterschicht (15) ausgekoppelt wird.

12. Oberflächenemittierender Photonischer-Kristall-Laser (1) nach einem der Ansprüche 1 bis 11, weiterhin aufweisend eine auf oder über der ersten Mantelschicht (25) angeordnete reflektierende Schicht (31, 32).

13. Oberflächenemittierender Photonischer-Kristall-Laser (1) nach einem der Ansprüche 1 bis 12, wobei die erste Mantelschicht (20) eine Mehrzahl von einzeln und unabhängig ansteuerbaren p-Anschlussbereichen (21) und/oder eine Mehrzahl von einzeln und unabhängig ansteuerbaren n-Anschlussbereichen (22) aufweist.

14. Oberflächenemittierender Photonischer-Kristall-Laser (1) nach Anspruch 13, wobei in einer Aufsicht betrachtet die p-Anschlussbereiche (21) und die n-Anschlussbereiche (22) schachbrettartig angeordnet sind.

15. Oberflächenemittierender Photonischer-Kristall-Laser (1) nach einem der Ansprüche 1 bis 14, wobei in einer Aufsicht betrachtet der zumindest eine p-Anschlussbereich (21) und der zumindest eine n-Anschlussbereich (22) als konzentrische Ringe ausgebildet sind.

16. Oberflächenemittierender Photonischer-Kristall-Laser (1) nach einem der Ansprüche 1 bis 15, weiterhin aufweisend zumindest ein erstes elektrisches Kontaktelement (31) und zumindest ein zweites elektrisches Kontaktelement (32), wobei auf jedem p-Anschlussbereich (21) ein jeweiliges erstes elektrisches Kontaktelement (31) angeordnet und diesem zugeordnet ist, und wobei auf jedem n-Anschlussbereich (22) ein jeweiliges zweites elektrisches Kontaktelement (32) angeordnet und diesem zugeordnet ist.

17. Optoelektronisches System (100) aufweisend einen oberflächenemittierenden Photonischer-Kristall-Laser (1) nach einem der Ansprüche 1 bis 16.

18. Verfahren zur Herstellung eines oberflächenemittierenden Photonischer-Kristall-Lasers (1), aufweisend:

   - Formen einer zweiten Wellenleiterschicht (15),
   - Aufbringen einer aktiven Schicht (5) auf der zweiten Wellenleiterschicht (15), wobei die aktive Schicht (5) zur Generierung elektromagnetischer Strahlung (99) durch Ladungsträgerrekombination ausgebildet ist,
   - Aufbringen einer ersten Wellenleiterschicht (10) auf der aktiven Schicht (5),
   - Aufbringen einer ersten Mantelschicht (20) auf der ersten Wellenleiterschicht (10),
   - Ausbilden zumindest eines p-Anschlussbereichs (21) der ersten Mantelschicht (20) zur Injektion von elektrisch positiven Ladungsträgern in die aktive Schicht (5) und zumindest eines n-Anschlussbereichs (22) der ersten Mantelschicht (20) zur Injektion von elektrisch negativen Ladungsträgern in die aktive Schicht (5),
   - Ausbilden von zueinander periodisch angeordnete Bereichen (41) und weitere Bereichen (42) der zweiten Wellenleiterschicht (15), wobei sich ein Brechungsindex der Bereiche (41) von einem Brechungsindex der weiteren Bereiche (42) unterscheidet, und wobei die Bereiche (41) und die weiteren Bereiche (42) einen photonischen Kristall (40) bilden.

**19.** Verfahren nach Anspruch 18, weiterhin aufweisend: Aufbringen eines ersten elektrischen Kontaktelements (31) auf jedem der p-Anschlussbereiche (21), und Aufbringen eines zweiten elektrischen Kontaktelements (32) auf jedem der n-Anschlussbereiche (22).

**20.** Verfahren nach Anspruch 18 oder 19, wobei das Ausbilden von zueinander periodisch angeordneten Bereichen (41) und weiteren Bereichen (42) der zweiten Wellenleiterschicht (15) umfasst:
Ausbilden von Gräben oder Löchern in die zweite Wellenleiterschicht (15), die sich von einer der aktiven Schicht (5) abgewandten Oberfläche der zweiten Wellenleiterschicht (15) bis in die zweite Wellenleiterschicht (15) hinein erstrecken, wobei die Bereiche (41) durch das Wellenleitermaterial definiert sind, und die weiteren Bereiche (42) durch von den Gräben oder Löchern gebildete Ausnehmungen definiert sind.

**Claims**

**1.** A surface-emitting photonic-crystal laser (1), comprising:

- an active layer (5) for generating electromagnetic radiation (99) by charge carrier recombination, the active layer (5) comprising a first main surface (5') and a second main surface (5") opposite the first main surface (5'),
- a first waveguide layer (10) arranged on the first main surface (5'),
- a second waveguide layer (15) arranged on the second main surface (5'') and comprising regions (41) and further regions (42) arranged periodically with respect to one another, wherein a refractive index of the regions (41) differs from a refractive index of the further regions (42), and wherein the regions (41) and the further regions (42) form a photonic crystal (40), and
- a first cladding layer (20) arranged on the first waveguide layer (10), the first cladding layer (20) comprising at least one p-connection region (21) for injecting electrically positive charge carriers into the active layer (5), **characterized in that** the first cladding layer (20) comprises at least one n-connection region (22) for injecting electrically negative charge carriers into the active layer (5).

**2.** The surface-emitting photonic-crystal laser (1) according to claim 1, wherein the second waveguide layer (15) comprises a material which defines the regions (41) of the second waveguide layer (15), and wherein the further regions (42) of the second waveguide layer (15) are defined by recesses of the second waveguide layer (15).

**3.** The surface-emitting photonic-crystal laser according to claim 2, wherein the recesses of the second waveguide layer (15) are formed by trenches or holes in the second waveguide layer (15), the trenches or holes extending from a surface of the second waveguide layer (15) facing away from the active layer (5) into the second waveguide layer (15).

**4.** The surface-emitting photonic-crystal laser (1) according to any one of claims 1 to 3, wherein the first waveguide layer (10) is undoped or intrinsically doped.

**5.** The surface-emitting photonic-crystal laser (1) according to any one of claims 1 to 4, wherein the second waveguide layer (15) is undoped or intrinsically doped.

**6.** The surface-emitting photonic-crystal laser (1) according to any one of claims 1 to 5, wherein a thickness of the first waveguide layer (10) is less than a thickness of the second waveguide layer (15).

**7.** The surface-emitting photonic-crystal laser (1) according to any one of claims 1 to 6, further comprising a second cladding layer (25) arranged on the second waveguide layer (15).

**8.** The surface-emitting photonic-crystal laser (1) according to claims 2 and 7, wherein the recesses of the second waveguide layer (15) are formed by trenches in the second waveguide layer (15) which extend from a surface (25') of the second cladding layer (25) facing away from the second waveguide layer into the second waveguide layer (15).

**9.** The surface-emitting photonic-crystal laser (1) according to any one of claims 7 to 8, wherein the second cladding layer (25) is undoped or intrinsically doped.

**10.** The surface-emitting photonic-crystal laser (1) according to any one of claims 1 to 9, wherein the active layer (5) forms at least one quantum well which is configured and formed to emit electromagnetic radiation (99) of a predetermined wavelength when a driving current is applied.

**11.** The surface-emitting photonic-crystal laser (1) according to any one of claims 1 to 10, wherein a radiation direction (z) of the laser (1) is perpendicular to a main extension plane of the second waveguide layer (15) and electromagnetic radiation (99) is outcoupled via a surface of the second waveguide layer (15) facing away from the active layer (5).

**12.** The surface-emitting photonic-crystal laser (1) according to any one of claims 1 to 11, further comprising a reflective layer (31, 32) arranged on or above the first cladding layer (25).

**13.** The surface-emitting photonic-crystal laser (1) according to any one of claims 1 to 12, wherein the first cladding layer (20) comprises a plurality of individually and independently controllable p-connection regions (21) and/or a plurality of individually and independently controllable n-connection regions (22).

**14.** The surface-emitting photonic-crystal laser (1) according to claim 13, wherein the p-connection regions (21) and the n-connection regions (22) are arranged in a checkerboard pattern when viewed from a top view.

**15.** The surface-emitting photonic-crystal laser (1) according to any one of claims 1 to 14, wherein the at least one p-connection region (21) and the at least one n-connection region (22) are formed as concentric rings when viewed from a top view.

**16.** The surface-emitting photonic-crystal laser (1) according to any one of claims 1 to 15, further comprising at least one first electrical contact element (31) and at least one second electrical contact element (32), wherein a respective first electrical contact element (31) is arranged on and associated with each p-connection region (21), and wherein a respective second electrical contact element (32) is arranged on and associated with each n-connection region (22).

**17.** An optoelectronic system (100) comprising a surface-emitting photonic-crystal laser (1) according to any one of claims 1 to 16.

**18.** A method of manufacturing a surface-emitting photonic-crystal laser (1), comprising:

- forming a second waveguide layer (15),
- applying an active layer (5) to the second waveguide layer (15), the active layer (5) being formed to generate electromagnetic radiation (99) by charge carrier recombination,
- applying a first waveguide layer (10) to the active layer (5),
- applying a first cladding layer (20) to the first waveguide layer (10),
- forming at least one p-connection region (21) of the first cladding layer (20) for injecting electrically positive charge carriers into the active layer (5) and at least one n-connection region (22) of the first cladding layer (20) for injecting electrically negative charge carriers into the active layer (5),

- forming regions (41) and further regions (42) of the second waveguide layer (15) arranged periodically with respect to one another, wherein a refractive index of the regions (41) differs from a refractive index of the further regions (42), and wherein the regions (41) and the further regions (42) form a photonic crystal (40).

**19.** The method according to claim 18, further comprising:
applying a first electrical contact element (31) to each of the p-connection regions (21), and applying a second electrical contact element (32) to each of the n-connection regions (22).

**20.** The method according to claim 18 or 19, wherein forming regions (41) and further regions (42) of the second waveguide layer (15) arranged periodically with respect to one another comprises:
forming trenches or holes in the second waveguide layer (15), which extend from a surface of the second waveguide layer (15) facing away from the active layer (5) into the second waveguide layer (15), wherein the regions (41) are defined by the waveguide material, and the further regions (42) are defined by recesses formed by the trenches or holes.

**Revendications**

**1.** Laser à cristal photonique à émission de surface (1), présentant :

- une couche active (5) pour générer un rayonnement électromagnétique (99) par recombinaison de porteurs de charge, dans lequel la couche active (5) présente une première surface principale (5') et une deuxième surface principale (5") opposée à la première surface principale (5'),
- une première couche conductrice d'ondes (10), disposée sur la première surface principale (5'),
- une deuxième couche conductrice d'ondes (15), disposée sur la deuxième surface principale (5"), qui présente des zones (41) et d'autres zones (42) disposées périodiquement les par rapport aux autres, dans lequel un indice de réfraction des zones (41) est différent d'un indice de réfraction des autres zones (42), et dans lequel les zones (41) et les autres zones (42) forment un cristal photonique (40), et
- une première couche de gaine (20), disposée sur la première couche conductrice d'ondes (10), qui présente au moins une zone de connexion p (21) pour l'injection de porteurs de charge électriquement positifs dans la couche active (5), **caractérisé en ce que**

- la première couche de gaine (20) présente au moins une zone de connexion n (22) pour l'injection de porteurs de charge électriquement négatifs dans la couche active (5).

**2.** Laser à cristal photonique à émission de surface (1) selon la revendication 1, dans lequel la deuxième couche conductrice d'ondes (15) présente un matériau qui définit les zones (41) de la deuxième couche conductrice d'ondes (15), et dans lequel les autres zones (42) de la deuxième couche conductrice d'ondes (15) sont définies par des évidements de la deuxième couche conductrice d'ondes (15).

**3.** Laser à cristal photonique à émission de surface selon la revendication 2, dans lequel les évidements de la deuxième couche conductrice d'ondes (15) sont formés par des fossés ou des trous dans la deuxième couche conductrice d'ondes (15) qui s'étendent depuis une surface de la deuxième couche conductrice d'ondes (15) opposée à la couche active (5) jusqu'à la deuxième couche conductrice d'ondes (15).

**4.** Laser à cristal photonique à émission de surface (1) selon l'une des revendications 1 à 3, dans lequel la première couche conductrice d'ondes (10) est non dopée ou est dopée intrinsèquement.

**5.** Laser à cristal photonique à émission de surface (1) selon l'une des revendications 1 à 4, dans lequel la deuxième couche conductrice d'onde (15) est non dopée ou est dopée intrinsèquement.

**6.** Laser à cristal photonique à émission de surface (1) selon l'une des revendications 1 à 5, dans lequel une épaisseur de la première couche conductrice d'ondes (10) est inférieure à une épaisseur de la deuxième couche conductrice d'ondes (15).

**7.** Laser à cristal photonique à émission de surface (1) selon l'une des revendications 1 à 6, présentant par ailleurs une deuxième couche de gaine (25), disposée sur la deuxième couche conductrice d'ondes (15).

**8.** Laser à cristal photonique à émission de surface (1) selon les revendications 2 et 7, dans lequel les évidements de la deuxième couche conductrice d'ondes (15) sont formés par des fossés dans la deuxième couche conductrice d'ondes (15) qui s'étendent d'une surface (25') de la deuxième couche de gaine (25) opposée à la deuxième couche conductrice d'ondes jusqu'à la deuxième couche conductrice d'ondes (15).

**9.** Laser à cristal photonique à émission de surface (1) selon l'une des revendications 7 à 8, dans lequel la deuxième couche de gaine (25) est non dopée ou est dopée intrinsèquement.

**10.** Laser à cristal photonique à émission de surface (1) selon l'une des revendications 1 à 9, dans lequel la couche active (5) forme au moins un pot quantique qui est prévu et réalisé pour émettre un rayonnement électromagnétique (99) d'une longueur d'onde prédéterminée sous l'application d'un courant pilote.

**11.** Laser à cristal photonique à émission de surface (1) selon l'une des revendications 1 à 10, dans lequel une direction de rayonnement (z) du laser (1) se trouve perpendiculairement sur un plan d'extension principal de la deuxième couche conductrice d'ondes (15) et un rayonnement électromagnétique (99) est découplé par une surface de la deuxième couche conductrice d'ondes (15) opposée à la couche active (5).

**12.** Laser à cristal photonique à émission de surface (1) selon l'une des revendications 1 à 11, présentant par ailleurs une couche réfléchissante (31, 32), disposée sur ou au-dessus de la première couche de gaine (25).

**13.** Laser à cristal photonique à émission de surface (1) selon l'une des revendications 1 à 12, dans lequel la première couche de gaine (20) présente une pluralité de zones de connexion p (21) pouvant être pilotées individuellement et indépendamment et/ou une pluralité de zones de connexion n (22) pouvant être pilotées individuellement et indépendamment.

**14.** Laser à cristal photonique à émission de surface (1) selon la revendication 13, dans lequel, dans une vue d'en haut, les zones de connexion p (21) et les zones de connexion n (22) sont disposées en damier.

**15.** Laser à cristal photonique à émission de surface (1) selon l'une des revendications 1 à 14, dans lequel, dans une vue d'en haut, l'au moins une zone de connexion p (21) et l'au moins une zone de connexion n (22) sont réalisées sous forme d'anneaux concentriques.

**16.** Laser à cristal photonique à émission de surface (1) selon l'une des revendications 1 à 15, présentant par ailleurs au moins un premier élément de contact électrique (31) et au moins un deuxième élément de contact électrique (32), dans lequel un premier élément de contact électrique (31) respectif est disposé sur chaque zone de connexion p (21) et lui est associé, et dans lequel un deuxième élément de contact électrique (32) respectif est disposé sur chaque zone de connexion n (22) et lui est associé.

**17.** Système optoélectronique (100) présentant un laser à cristal photonique à émission de surface (1) selon l'une des revendications 1 à 16.

18. Procédé de fabrication d'un laser à cristal photonique à émission de surface (1), présentant les étapes suivantes :

> - former une deuxième couche conductrice d'ondes (15),
> - appliquer une couche active (5) sur la deuxième couche conductrice d'ondes (15), dans lequel la couche active (5) est réalisée pour générer un rayonnement électromagnétique (99) par recombinaison de porteurs de charge,
> - appliquer une première couche conductrice d'ondes (10) sur la couche active (5),
> - appliquer une première couche de gaine (20) sur la première couche conductrice d'ondes (10),
> - réaliser au moins une zone de connexion p (21) de la première couche de gaine (20) pour l'injection de porteurs de charge électriquement positifs dans la couche active (5) et d'au moins une zone de connexion n (22) de la première couche de gaine (20) pour l'injection de porteurs de charge électriquement négatifs dans la couche active (5),
> - réaliser des zones (41) et d'autres zones (42) de la deuxième couche conductrice d'ondes (15) disposées périodiquement les unes par rapport aux autres, dans lequel un indice de réfraction des zones (41) diffère d'un indice de réfraction des autres zones (42), et dans lequel les zones (41) et les autres zones (42) forment un cristal photonique (40).

19. Procédé selon la revendication 18, présentant par ailleurs l'étape suivante :
appliquer un premier élément de contact électrique (31) sur chacune des zones de connexion p (21), et appliquer un deuxième élément de contact électrique (32) sur chacune des zones de connexion n (22).

20. Procédé selon la revendication 18 ou 19, dans lequel la réalisation de zones (41) et d'autres zones (42) disposées périodiquement les unes par rapport aux autres de la deuxième couche conductrice d'ondes (15) comprend l'étape suivante :
réaliser des fossés ou des trous dans la deuxième couche conductrice d'ondes (15) qui s'étendent d'une surface de la deuxième couche conductrice d'ondes (15) opposée à la couche active (5) jusqu'à la deuxième couche conductrice d'ondes (15), dans lequel les zones (41) sont définies par le matériau de conducteur d'ondes, et les autres zones (42) sont définies par des évidements formés par les fossés ou trous.

FIG 1

FIG 2

## FIG 3

## FIG 4

# FIG 5

# FIG 6

FIG 7

FIG 8

## FIG 9

34
20
10
5
15
25
50

## FIG 10

34
21 22
20
10
5
15
25
50

## FIG 11

## FIG 12

FIG 13

FIG 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2021184431 A1, NODA
- US 2020036163 A1, NISHIOKA
- US 2005029536 A1, SUGITATSU